(19) Europäisches Patentamt
European Patent Office
Office européen des brevets

(11) **EP 4 716 124 A1**

(12) **EUROPEAN PATENT APPLICATION**
published in accordance with Art. 153(4) EPC

(43) Date of publication:
**25.03.2026 Bulletin 2026/13**

(21) Application number: **24809924.4**

(22) Date of filing: **11.01.2024**

(51) International Patent Classification (IPC):
**H04L 1/00** (2006.01)

(52) Cooperative Patent Classification (CPC):
**H04L 1/00**

(86) International application number:
**PCT/CN2024/071818**

(87) International publication number:
**WO 2024/239673 (28.11.2024 Gazette 2024/48)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **22.05.2023 CN 202310583281**

(71) Applicant: **ZTE Corporation
Shenzhen, Guangdong 518057 (CN)**

(72) Inventors:
• **LI, Liguang**
  **Shenzhen, Guangdong 518057 (CN)**
• **XU, Jin**
  **Shenzhen, Guangdong 518057 (CN)**

• **LIANG, Chulong**
  **Shenzhen, Guangdong 518057 (CN)**
• **ZHAO, Wei**
  **Shenzhen, Guangdong 518057 (CN)**
• **YU, Guanghui**
  **Shenzhen, Guangdong 518057 (CN)**
• **FU, Qiang**
  **Shenzhen, Guangdong 518057 (CN)**
• **KANG, Jian**
  **Shenzhen, Guangdong 518057 (CN)**
• **MU, Lin**
  **Shenzhen, Guangdong 518057 (CN)**

(74) Representative: **Ziebig Hengelhaupt Intellectual
Property Attorneys
Patentanwaltskanzlei PartGmbB
Leipziger Straße 49
10117 Berlin (DE)**

(54) **CODING METHOD, DECODING METHOD, COMMUNICATION APPARATUS AND STORAGE MEDIUM**

(57) The present application relates to the technical field of communications. Provided in the embodiments of the present application are a coding method, a decoding method, a communication apparatus and a storage medium, which are used for reducing the convolutional coding complexity. The coding method specifically comprises: first, acquiring an information bit sequence; according to T component code generation polynomials, performing convolutional coding on the information bit sequence, so as to obtain T component code output bit sequences, T being an integer greater than 1; performing sub-block interleaving on an i-th component code output bit sequence, so as to obtain a sub-block interleaved output sequence, i being a non-negative integer less than T; and, according to the sub-block interleaved output sequence and the other component code output bit sequences excepting the i-th component code output bit sequence among the T component code output bit sequences, determining a coded bit sequence.

```
┌─────────────────────────────────────────────┐
│   Acquire an information bit sequence         │───⟋ S101
└─────────────────────────────────────────────┘
                     │
┌─────────────────────────────────────────────┐
│ According to T component code generation      │
│ polynomials, perform convolutional coding on  │───⟋ S102
│ the information bit sequence, so as to obtain  │
│ T component code output bit sequences         │
└─────────────────────────────────────────────┘
                     │
┌─────────────────────────────────────────────┐
│ Perform sub-block interleaving on an i-th     │
│ component code output bit sequence, so as to  │───⟋ S103
│ obtain a sub-block interleaved output         │
│ sequence                                      │
└─────────────────────────────────────────────┘
                     │
┌─────────────────────────────────────────────┐
│ According to the sub-block interleaved output │
│ sequence and the other component code bit     │
│ sequences excepting the i-th                  │───⟋ S104
│ component code bit sequence among the T       │
│ component code bit sequences, determine a     │
│ coded bit sequence                            │
└─────────────────────────────────────────────┘
```
FIG. 2

**Description**

The present disclosure claims a priority to Chinese Patent Application No. 202310583281.7, and filed on May 22, 2023, the entire content of which is incorporated into the present application by reference.

TECHNICAL FIELD

The present disclosure relates to the field of communication technologies, and in particular, to an encoding and decoding method, a communication apparatus, and a storage medium.

BACKGROUND

With the rapid development of technologies such as big data, cloud computing, and latency-sensitive networks, etc., a number of user equipments in wireless communication networks has experienced explosive growth. The wireless communication networks will carry a variety of applications and massive amounts of data, which puts high demands on data transmission rate, throughput, reliability, latency, etc. Currently, with the development of intelligent transportation, intelligent industrial control, intelligent logistics, etc., the demand for ultra-low latency and ultra-high reliability communications is becoming increasingly urgent, and some short packet data needs to be sent and successfully received within an extremely short period of time.

However, the channel encoding of short packets is relatively complex at present and how to further reduce the complexity of channel coding for short packets is an urgent problem to be solved in the industry.

SUMMARY

The present disclosure provides an encoding and decoding method, a communication apparatus, and a storage medium for reducing the complexity of convolutional encoding.

To achieve the above-mentioned objectives, the present disclosure adopts the following technical solutions.

In a first aspect, an encoding method is provided, and the method specifically includes:

acquiring an information bit sequence;
performing convolutional encoding on the information bit sequence according to T component code generation polynomials, to obtain T component code output bit sequences, where T is an integer greater than 1;
performing sub-block interleaving on an i-th component code output bit sequence, to obtain a sub-block interleaved output sequence, where i is a non-negative integer less than T; and
determining an encoded bit sequence according to the sub-block interleaved output sequence and other component code bit sequences among the T component code bit sequences and except the i-th component code bit sequence.

In a second aspect, a decoding method is provided, and the method includes:

receiving a to-be-decoded soft bit sequence;
performing de-bit selection on the to-be-decoded soft bit sequence, to obtain soft bit subsequences of T component codes;
performing sub-block deinterleaving on a soft bit subsequence of an i-th component code to obtain a deinterleaved bit subsequence of the i-th component code, where i is a non-negative integer less than T; and
performing convolutional decoding on the deinterleaved bit subsequence of the i-th component code and soft bit subsequences of other component codes among the T component codes and except the i-th component code according to the T component code generation polynomials, to obtain an information bit sequence.

In a third aspect, an encoding apparatus is provided, and includes:

an acquiring module, configured to acquire an information bit sequence;
a processing module, perform convolutional encoding on the information bit sequence according to T component code generation polynomials, to obtain T component code output bit sequences, where T is an integer greater than 1;
the processing module, further configured to perform sub-block interleaving on an i-th component code output bit sequence, to obtain a sub-block interleaved output sequence, where i is a non-negative integer less than T;
the processing module, further configured to determine an encoded bit sequence according to the sub-block interleaved output sequence and other component code bit sequences among the T component code bit sequences and except the i-th component code bit sequence.

In a fourth aspect, a decoding apparatus is provided, and includes:

a receiving module, configured to receive a to-be-decoded soft bit sequence;

a processing module, configured to perform de-bit selection on the to-be-decoded soft bit sequence, to obtain soft bit subsequences of T component codes;

the processing module, further configured to perform sub-block deinterleaving on a soft bit subsequence of an i-th component code, to obtain a deinterleaved bit subsequence of the i-th component code, where i is a non-negative integer less than T;

the processing module, further configured to perform convolutional decoding on the deinterleaved bit subsequence of the i-th component code and soft bit subsequences of other component codes among the T component codes and except the i-th component code according to T component code generation polynomials, to obtain an information bit sequence.

In a fifth aspect, a communication apparatus is provided, and includes: a processor and a memory; the memory has stored instructions executable by the processor; the processor is configured to execute the instructions, so that the communication apparatus implements any of the methods provided in the first aspect or the second aspect above.

In a sixth aspect, a computer readable storage medium is provided, the computer readable storage medium stores computer instructions, and the computer instructions, when executed on a computer, cause the computer to perform any of the methods provided in the first aspect or the second aspect above.

In a seventh aspect, a computer program product containing computer instructions is provided, and the computer instructions, when executed on a computer, cause the computer to perform any of the methods provided in the first aspect or the second aspect above.

Based on the above embodiments, the method may perform convolutional encoding on the information bit sequence based on a preset component code generation polynomial, select one of the component code output bit sequences for sub-block interleaving, to obtain a sub-block interleaved output sequence, and determine the encoded bit sequence based on the sub-block interleaved output sequence and the other component code output bit sequences. In this scheme, sub-block interleaving is not required for the other component code output bit sequences. Thus, the interleaving process of convolutional encoding may be reduced and the complexity of encoding may be reduced.

BRIEF DESCRIPTION OF THE DRAWINGS

The drawings are used to provide a further understanding for the technical solutions of the present disclosure, constitute a part of the specification, are used to explain the technical solutions of the present disclosure in conjunction with the embodiments of the present disclosure, and do not constitute a limitation on the technical solutions of the present disclosure.

FIG. 1 is a schematic diagram of an architecture of a communication system, provided by the embodiments of the present disclosure.

FIG. 2 is a schematic flowchart of an encoding method, provided by the embodiments of the present disclosure.

FIG. 3 is a schematic diagram of a convolutional encoding process, provided by the embodiments of the present disclosure.

FIG. 4 is a schematic diagram of an encoded bit sequence provided by the embodiments of the present disclosure.

FIG. 5 is a schematic flowchart of a decoding method, provided by the embodiments of the present disclosure.

FIG. 6 is a schematic diagram of components of an encoding apparatus, provided by the embodiments of the present disclosure.

FIG. 7 is a schematic diagram of components of a decoding apparatus, provided by the embodiments of the present disclosure.

FIG. 8 is a structural schematic diagram of a communication apparatus, provided by the embodiments of the present disclosure.

DETAILED DESCRIPTION

The technical solutions in the embodiments of the present disclosure will be described clearly and completely below in conjunction with the drawings in the embodiments of the present disclosure, and it is obvious that the described embodiments are only a part of the embodiments of the present disclosure, but not all of the embodiments. Based on the embodiments of the present disclosure, all other embodiments obtained by those ordinary skilled in the art without making inventive efforts fall within the scope of protection of the present disclosure.

In the description of the present disclosure, unless otherwise specified, the symbol "/" means "or", and for example, A/B may represent A or B. Herein, "and/or" is only used to describe an associated relationship between associated objects, representing that there may be three relationships, and for example, A and/or B may represents three cases: only A, A and B, and only B. Additionally, "at least one" means one or more, and "multiple/plurality of" means two or more. Words, such as "first" and "second", etc., do not limit the quantity and execution order, and the words, such as "first" and "second", etc., also do not necessarily limit different items.

It should be noted that in the present disclosure, terms such as "exemplary/exemplarily" or "for example" are used to represent examples, illustrations, or descriptions. Any embodiment or design solution described with "exemplary/exemplarily" or "for example" should not be interpreted as being more preferred or advantageous than other embodiments or design solutions. Specifically, the use of the terms such as "exemplary/exemplarily" or "for example", etc., is intended to present related concepts in a specific manner.

In a wireless communication system, a sending end performs channel encoding on to-be-transmitted data, to obtain an encoded bit sequence, then maps the encoded bit sequence into a constellation modulation symbol and sends the constellation modulation symbol to a receiving end. In a data transmission channel, data transmission is distorted due to the influence of factors such as multi-path, movement, noise, and interference. The sending end adds some redundant information to the to-be-transmitted data through channel encoding. The receiving end may restore to-be-transmitted original data through this redundant information, that is, eliminate the distortion caused by the data during the transmission process. The receiving end needs to perform channel decoding on the received constellation modulation symbol, so as to restore the to-be-transmitted data.

Currently, commonly used channel encoding methods may include low-density parity-check encoding, polarization encoding, and convolutional encoding, etc. Low-density parity-check encoding is defined by a sparse (or low-density) parity-check matrix. Decoding performance may be improved through iterative decoding, such as using belief transfer decoding. The encoding end needs to store a parity-check matrix and perform a large number of XOR operations, which is relatively complex. Polar encoding is a type of linear block code proposed based on channel polarization theory. It is theoretically proven that it can reach the Shannon limit when the code length is infinite. Polar encoding generally uses a successive cancellation list (SCL) decoding algorithm. However, the encoding end still needs to perform numerous XOR operations and rate matching, resulting in slightly higher complexity. Convolutional encoding groups input information bits into information groups consisting of one or more bits. Encoded output bits of each information group are related not only to the information bits of the group at current moment, but also to the information bits of other groups at a previous moment.

Therefore, in order to further reduce the complexity of channel coding, the embodiments of the present disclosure provide an encoding method, and the method specifically includes: first acquiring an information bit sequence, performing convolutional encoding on the information bit sequence according to T component code generation polynomials, to obtain T component code output bit sequences, where T is an integer greater than 1, performing sub-block interleaving on an i-th component code output bit sequence, to obtain a sub-block interleaved output sequence, where i is a non-negative integer less than T, and determining an encoded bit sequence according to the sub-block interleaved output sequence and other component code bit sequences among the T component code bit sequences and except the i-th component code bit sequence. In this way, the interleaving process of convolutional encoding may be reduced, to reduce the complexity of encoding.

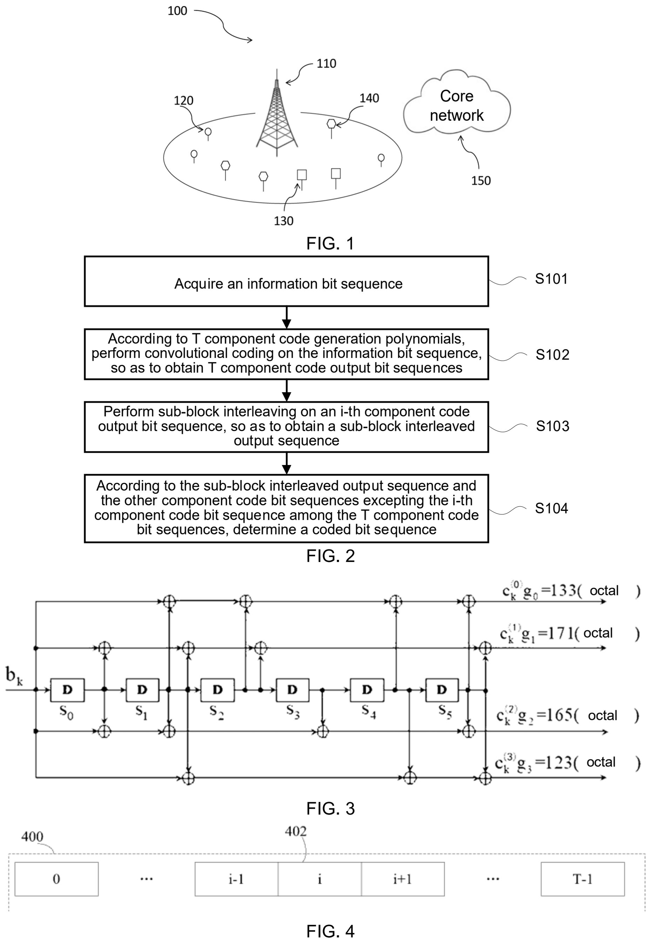

The method provided in the embodiments of the present disclosure may be applied to various communication systems. For example, the communication system may be a long term evolution (LTE) system, a 5th generation (5G) communication system, a Wireless Fidelity (Wi-Fi) system, a 3rd generation partnership project (3GPP)-related communication system, a future evolved communication system (e.g., a 6th generation (6G) communication system, etc.), or a system integrating multiple systems, etc., which is not limited thereto. A communication system 100 shown in FIG. 1 is take as an example below, to describe the method provided in the embodiments of the present disclosure. FIG. 1 is merely a schematic diagram and does not constitute a limitation on the applicable scenarios of the technical solutions provided in the present disclosure.

FIG. 1 is a schematic diagram of an architecture of a communication system, provided by the embodiments of the present disclosure. As shown in FIG. 1, the communication system 100 may include one or more network devices and one or more terminal devices. As shown in FIG. 1, the communication system 100 may include a network device 110, a terminal device 120, a terminal device 130, a terminal device 140 and a core network 150.

Herein, the network device 110 may provide communication services for the terminal device 120, the terminal device 130, and the terminal device 140, and the network device 110 may also communicate with the core network 150.

In some embodiments, the core network may provide functions, such as access authorization, user authentication, Internet Protocol (IP) connectivity, tracking, and other access, routing, or mobility management, etc. The core network may be an access and mobility management function (AMF) entity with functions, such as access control, mobility management, attachment and detachment, and gateway selection, etc. Alternatively, the core network device is a user plane function (UPF) entity with functions, such as data routing/forwarding and quality of service (QoS) flow processing, etc. It should be noted that, the core network device may also be other core network devices, which is not specifically limited to the present disclosure.

In some embodiments, the network device may be used to implement functions, such as resource scheduling, radio resource management, and radio access control, etc., of terminal devices. Specifically, the network device may be any one of a base station transceiver, a radio base station, a radio transceiver, a small base station, a radio access point, a receiving and sending point (transmission receive point, TRP), a transmission point (TP), an evolved node B (eNB), a home node B, a home evolved node B, a reader/writer, and some other access nodes. In some embodiments, the communication system 100 may further include different types of base stations, such as a macro cell base station and/or a small cell base station.

The terminal device may also be referred to as a terminal, a user equipment (UE), a mobile station, a mobile terminal, etc. The terminal device may be an Internet of Things (internet of things, IoT) device, which is used to collect various information and then perform forward error correction encoding on the data before sending the data to the base station. The terminal device may be a mobile phone, a Pad, a computer with a wireless transceiving function, an automobile, an electric vehicle, etc. Furthermore, the terminal device may be either fixed or mobile. Various types of terminal devices may also include or be referred to by those skilled in the art as mobile stations, user stations, mobile units, user units, wireless units, remote units, mobile devices, wireless devices, wireless communication devices, remote devices, mobile user stations, access terminals, mobile terminals, wireless terminals, remote terminals, handheld devices, user agents, mobile clients, clients, passive tags (Passive Tag), or some other possible devices. Furthermore, various types of UEs may also be cellular phones, personal digital assistants (Personal Digital Assistant, PDA), wireless modems, wireless communication devices, handheld devices, tablet computers, laptop computers, cordless phones, wireless local loop (Wireless Local Loop, WLL) stations, and the like. Various types of UEs may communicate with various types of base stations and network devices (including macro eNBs, small cell eNBs, relay base stations, etc.). The wireless communication system 100 may also include an IoT system or be a part of an IoT system.

It should be noted that, FIG. 1 is only an exemplary frame diagram, and a number of nodes and names of the various devices included in FIG. 1 are not limited, and in addition to the functional nodes shown in FIG. 1, the communication system may also include other nodes.

It should be noted that, the communication system shown in FIG. 1 is only for the purpose of more clearly explaining the technical solutions of the present disclosure and does not constitute a limitation on the present disclosure, and the ordinary skilled in the art may know that with the evolution of the network architectures and the emergence of new service scenarios, the technical solutions provided in the present disclosure are also applicable to similar technical problems.

The embodiments provided in the present disclosure will be specifically introduced in detail below in conjunction with the drawings of the specification.

As shown in FIG. 2, the embodiments of the present disclosure provide an encoding method, and the method at least includes S101 to S104.

In S101, an information bit sequence is acquired.

Herein, the information bit sequence may be a sequence of information bits to be sent by the sending end, that is, a sequence of bits to be encoded by the sending end, and the information bit refers to a bit used to carry information. Exemplarily, the information bit sequence may be represented as $b_0$, $b_1$, $b_2$, $b_3$, ..., $b_{K-1}$, where K is a length of the information bit sequence and K is an integer greater than 0.

Taking as an example of the communication system 100 shown in FIG. 1, the sending end may be a terminal device or a network device in the communication system 100. In a communication process, if a network device sends data to a terminal device and the terminal device receives the data sent from the network device, the network device may be referred to as a sending end. Accordingly, the terminal device may be referred to as the receiving end.

In S102, convolutional encoding is performed on the information bit sequence according to T component code generation polynomials, to obtain T component code output bit sequences.

Herein, T is an integer greater than 1. Exemplarily, values of T include 2, 3, 4, 6, 8, 10, or 12.

In some embodiments, the convolutional encoding is implemented by a plurality of shift registers and a plurality of XOR gates, where every two adjacent shift registers among the plurality of shift registers are connected in series. Furthermore, any one of the component code output bit sequences is obtained by performing an XOR operation on the input bits and the bits of a part of the shift registers.

Exemplarily, the convolutional encoding process based on the plurality of shift registers and the plurality of XOR gates is explained below:

in a convolutional encoding process, only 1 bit is stored in each shift register. At a 0-th clock beat, the sending end may perform encoding based on the T component code generation polynomials, the data stored in the shift registers, and the 0-th bit of the information bit sequence (that is, the current input bit), to obtain T bits. Herein, the T bits respectively correspond to the 0-th bit in the T component code output bit sequences.

At a first clock beat, bit data of the 0-th shift register is stored in a 1st shift register, bit data of the 1st shift register is stored in a 2nd shift register, and so on, bit data of the (m-2)-th shift register is stored in the (m-1)-th shift register, and the 0-th bit of the information bit sequence is stored in the 0-th shift register, where m is a number of the shift registers.

Furthermore, the sending end may encode based on the adjusted stored data in the shift register, the T component code generation polynomials and the first bit of the information bit sequence, to obtain T bits, and the T bits respectively correspond to the first bit in the T component code output bit sequences.

Taking an example of an encoding operation of the 1st clock beat, the encoding operations of the 2nd, 3rd, 4th, ..., nth clock beats are performed sequentially to respectively obtain the 2nd bit, 3rd bit, 4th bit, ..., nth bit in the T component code output bit sequences, until the (K-1)-th clock beat, the (T-1)-th bit in the T component code output bit sequences may be obtained. Herein, K is a length of the information bit sequence, and K is an integer greater than 0.

In some embodiments, a number of shift registers is determined based on a highest power of T component code generation polynomials. For example, if a highest power of a component code generation polynomial is equal to 6, then a number of shift registers is equal to 6.

In some embodiments, a number of XOR gates is determined based on a number of coefficients of the T component code generation polynomials. It should be understood that, if the greater the number of coefficients of the T component code generation polynomials, the greater the number of XOR gates, and thus the higher the complexity of the convolutional encoder. Correspondingly, the smaller the number of coefficients of the T component code generation polynomials, the smaller the number of XOR gates, and thus the lower the complexity of the convolution encoder.

In some embodiments, a weight of the component code is determined based on a number of "1"s in the component code generation vector, that is, a number of non-zero coefficients in the T component code generation polynomials. Also, the larger the weight of the component code, the higher the complexity of the convolutional encoder. The smaller the weight of the component code, the lower the complexity of the convolutional encoder.

In some embodiments, a constraint length for the convolutional encoding is determined based on a highest power of a polynomial among the generation polynomials of the T component codes. Exemplarily, the constraint length for the convolutional encoding may be a sum of the highest power of the polynomial among the generation polynomials of the T component codes and 1.

In some embodiments, the constraint length for the convolutional encoding may be at least one of: 5, 6, 7, 8, 9, 10, 11. In an example, the constraint lengths for the convolutional encoding are 7 and 9. In another example, the constraint lengths for the convolutional encoding are 5 and 9. In yet another example, the constraint lengths for the convolutional encoding are equal to 7 and 11. In yet another example, the constraint lengths for the convolutional encoding are 7, 9, and 11.

In some embodiments, the T component code generation polynomials may be determined from a preset component code generation polynomial group. Several possible implementations of the preset component code generation polynomial group are shown below:

Implementation 1

A value of the constraint length for the convolutional encoding is 7, in this case, the number of shift registers required may be 7-1=6, and the highest power of the preset component code generation polynomial group is 6. The preset component code generation polynomial group includes at least one of following component code generation polynomials:

$$g_0(D) = 1 + D^2 + D^3 + D^5 + D^6;$$

$$g_1(D) = 1 + D^1 + D^2 + D^3 + D^6;$$

$$g_2(D) = 1 + D^1 + D^2 + D^4 + D^6;$$

$$g_3(D) = 1 + D^2 + D^5 + D^6.$$

The octal numbers corresponding to the four component code generation polynomials are 133, 171, 165, and 123 respectively. When binary representation is used, the four component code generation vectors are: {1, 0, 1, 1, 0, 1, 1}, {1, 1, 1, 1, 0, 0, 1}, {1, 1, 1, 0, 1, 0, 1}, and {1, 0, 1, 0, 0, 1, 1}. It should be noted that, in the component code generation vectors represented by binary, a last bit value of various generation vectors corresponds to the higher power of the component code generation polynomial, and a first bit value corresponds to a lower power of the component code generation polynomial. Therefore, the corresponding component code generation vector represented in binary may be determined based on the corresponding respective coefficients in the component code generation polynomial. It should be noted that, the three representation methods used in this document for convolutional encoding: component code generation polynomial, component code generation vector represented in binary, and component code generation polynomial represented in octal, and these three representation methods are completely equivalent. Any component code generation polynomial has a corresponding component code generation vector represented in binary and a component code generation polynomial represented in octal. Therefore, when the convolutional encoding is described, only any one of the representation methods may be used. For example, the convolutional encoding may be described using only the component code generation polynomial represented in octal, or using only the component code generation polynomial, or using only the component code generation vector represented in binary.

In some embodiments, the weight of the four component codes obtained based on the above component code generation polynomials is equal to 19, where the weight of the component code refers to the number of "1"s in the four component code generation vectors. In general, the number of "1" in the generation vector is positively proportional to the number of XOR gates required, that is, the more the number of "1", the more XOR gates are required and the higher the complexity. Under a same performance, if the number of "1" in the generation vector is smaller, it is more beneficial for the corresponding hardware implementation, that is, the implementation is simpler.

If the information bit sequence is $b_0$, $b_1$, $b_2$, $b_3$, ..., $b_{K-1}$, the convolutional encoding process is shown in FIG. 3, the number of shift registers passed, that is, the number of delayed clock beats, may be determined based on the power of "D" in the component code generation polynomial. For example, $g_0(D) = 1 + D^2 + D^3 + D^5 + D^6$ represents that the output bits of the component code corresponding to the generation polynomial are the result of XOR operation on the no-delayed bit (1 information bit), the output of the second shift register (after passing through 2 delayers, corresponding to the shift register $S_1$), the output of the third shift register (after passing through 3 delayers, corresponding to the shift register $S_2$), the output of the fifth shift register (after passing through 5 delayers, corresponding to the shift register $S_4$), and the output of the sixth shift register (after passing through 6 delayers, corresponding to the shift register $S_5$). Similarly, $g_1(D) = 1 + D^1 + D^2 + D^3 + D^6$ represents that the output bits of the component code corresponding to the generation polynomial are the result of XOR operation on the no-delayed bit (1 information bit), the output of the first shift register (after passing through 1 delayer, corresponding to the shift register $S_0$), the output of the second shift register (after passing through 2 delayers, corresponding to the shift register $S_1$), the output of the third shift register (after passing through 3 delayers, corresponding to the shift register $S_2$), and the output of the sixth shift register (after passing through 6 delayers, corresponding to the shift register $S_5$).

The preset component code generation polynomial group includes the following component code generation polynomials: $g_0(D) = 1 + D^2 + D^3 + D^5 + D^6$; $g_1(D) = 1 + D^1 + D^2 + D^3 + D^6$; $g_2(D) = 1 + D^1 + D^2 + D^4 + D^6$; $g_3(D) = 1 + D^2 + D^5 + D^6$. Convolutional encoding is performed according to T=4 component code generation polynomials in the component code generation polynomial group. Furthermore, the component code output bit sequences corresponding to the above 4 component code generation polynomials respectively are: $C^{(0)}$, $C^{(1)}$, $C^{(2)}$ and $C^{(3)}$. Herein, based on octal numbers, the octal number of the output bit sequence of the component code $C^{(0)}$ corresponding to the generation polynomial of the component code is $g_0$=133, the octal number of the output bit sequence of the component code $C^{(1)}$ corresponding to the generation polynomial of the component code is $g_1$=171, the octal number of the output bit sequence of the component code $C^{(2)}$ corresponding to the generation polynomial of the component code is $g_2$=165, and the octal number of the output bit sequence of the component code $C^{(3)}$ corresponding to the generation polynomial of the component code is $g_3$=123.

In some embodiments, the convolutional encoding manner may be tail-biting convolutional code (TBCC). Therefore, initial values of the six shift registers in FIG. 3 may be equal to the values of the last six bits of the information bit sequence, so as to guarantee that a first state and a last state of the convolutional encoding are the same.

For example, the shift register includes $S_0$, $S_1$, $S_2$, $S_3$, $S_4$ and $S_5$, and its initial value is set to $S_a = b_{(K-1-a)}$, a=0, 1, ..., 5. The output corresponding to the a-th component code is $C^{(a)}$, where a=0, 1, ..., T-1, that is, inputting the k-th bit for convolutional encoding may obtain the k-th bit in the output bit sequence of the corresponding T component codes represented as $C_k^{(0)}$, $C_k^{(1)}$, ..., $C_k^{(T-1)}$, where k=0, 1, ..., K - 1. Exemplarily, when the code rate used for convolutional encoding is 1/2, a total of 2 component code output bit sequences may be obtained by performing convolutional encoding by the component code generation polynomials $g_0(D)$ and $g_1(D)$ and in this case, T=2. When the code rate is 1/4, a total of 4 component code output bit sequences may be obtained by performing convolutional encoding by the component code generation polynomials $g_0(D)$, $g_1(D)$, $g_2(D)$ and $g_3(D)$ and in this case, T= 4.

Implementation 2

A value of the constraint length for the convolutional encoding is 7, in this case, the number of shift registers required may be 7-1=6, and the highest power of the preset component code generation polynomial group is 6 and the preset component code generation polynomial group includes at least one of following component code generation polynomials:

$$g_0(D) = 1 + D^1 + D^3 + D^4 + D^6;$$

$$g_1(D) = 1 + D^3 + D^4 + D^5 + D^6;$$

$$g_2(D) = 1 + D^2 + D^4 + D^5 + D^6;$$

$$g_3(D) = 1 + D^1 + D^2 + D^3 + D^6;$$

$$g_4(D) = 1 + D^2 + D^3 + D^4 + D^6;$$

$$g_5(D) = 1 + D^1 + D^2 + D^3 + D^5 + D^6;$$

$$g_6(D) = 1 + D^2 + D^3 + D^4 + D^6;$$

$$g_7(D) = 1 + D^1 + D^4 + D^6;$$

$$g_8(D) = 1 + D^1 + D^3 + D^4 + D^5 + D^6;$$

$$g_9(D) = 1 + D^2 + D^3 + D^4 + D^6;$$

$$g_{10}(D) = 1 + D^3 + D^4 + D^5 + D^6;$$

$$g_{11}(D) = 1 + D^2 + D^3 + D^4 + D^6.$$

The octal numbers corresponding to the above component code generation polynomials are 155, 117, 127, 171, 135, 173, 135, 145, 157, 135, 117, and 135 respectively. When binary representation is used, the component code generation vectors respectively are: {1, 1, 0, 1, 1, 0, 1}, {1, 0, 0, 1, 1, 1, 1}, {1, 0, 1, 0, 1, 1, 1}, {1, 1, 1, 1, 0, 0, 1}, {1, 0, 1, 1, 1, 0, 1}, {1, 1, 1, 1, 0, 1, 1}, {1, 0, 1, 1, 1, 0, 1}, {1, 1, 0, 0, 1, 0, 1}, {1, 1, 0, 1, 1, 1, 0, 1}, {1, 0, 1, 1, 1, 1, 0, 1}, {1, 0, 0, 1, 1, 1, 1} 1, 1, 1} and {1, 0, 1, 1, 1, 0, 1}.

Furthermore, the sending end may determine the T component code generation polynomials for convolutional encoding from the above component code generation polynomial group. Herein, T may be equal to 2, 3, 4, 5, 6, 8, 10, or 12.

In some embodiments, the T component code generation polynomials used in the convolutional encoding include at least the first J component code generation polynomials among the above 12 generation polynomials. Herein, the value of J may be 2, 3, 4, 5, 6, 7, 8, 9, 10, or 12, and J is an integer less than or equal to T.

In an example, the convolutional encoding uses at least 2 of the above 12 generation polynomials for encoding, to obtain the T=2 component code output bit sequences, for example, at least the above generation polynomials $g_0(D) = 1 + D^1 + D^3 + D^4 + D^6$ and $g_1(D) = 1 + D^3 + D^4 + D^5 + D^6$ are used to perform convolutional encoding, to obtain the T=2 component code output bit sequences.

In another example, the convolutional encoding uses at least 3 of the above 12 generation polynomials for encoding, to obtain T=3 component code output bit sequences, for example, at least the above generation polynomials $g_0(D) = 1 + D^1 + D^3 + D^4 + D^6$, $g_1(D) = 1 + D^3 + D^4 + D^5 + D^6$ and $g_2(D) = 1 + D^2 + D^4 + D^5 + D^6$ are used to perform convolutional encoding, to obtain the T=3 component code output bit sequences.

In yet another example, the convolutional encoding uses at least 4 of the above 12 generation polynomials for encoding, to obtain T= 4 component code output bit sequences, for example, at least the above generation polynomials $g_0(D) = 1 + D^1 + D^3 + D^4 + D^6$, $g_1(D) = 1 + D^3 + D^4 + D^5 + D^6$, $g_2(D) = 1 + D^2 + D^4 + D^5 + D^6$ and $g_3(D) = 1 + D^1 + D^2 + D^3 + D^6$ are used to perform the convolutional encoding, to obtain the T= 4 component code output bit sequences.

In yet another example, the convolutional encoding uses at least 6 of the above 12 generation polynomials for encoding, to obtain T= 6 component code output bit sequences, for example, at least the above generation polynomials $g_0(D) = 1 + D^1 + D^3 + D^4 + D^6$, $g_1(D) = 1 + D^3 + D^4 + D^5 + D^6$, $g_2(D) = 1 + D^2 + D^4 + D^5 + D^6$, $g_3(D) = 1 + D^1 + D^2 + D^3 + D^6$, $g_4(D) = 1 + D^2 + D^3 + D^4 + D^6$ and $g_5(D) = 1 + D^1 + D^2 + D^3 + D^5 + D^6$ are used to perform the convolutional encoding, to obtain the T= 6 component code output bit sequences.

In yet another example, the convolutional encoding uses at least 8 of the above 12 generation polynomials for encoding, to obtain T= 8 component code output bit sequences, for example, at least the above generation polynomials $g_0$(D) = 1 + $D^1$ + $D^3$ + $D^4$ + $D^6$, $g_1$(D) = 1 + $D^3$ + $D^4$ + $D^5$ + $D^6$, $g_2$(D) = 1 + $D^2$ + $D^4$ + $D^5$ + $D^6$, $g_3$(D) = 1 + $D^1$ + $D^2$ + $D^3$ + $D^6$, $g_4$(D) = 1 + $D^2$ + $D^3$ + $D^4$ + $D^6$, $g_5$(D) = 1 + $D^1$ + $D^2$ + $D^3$ + $D^5$ + $D^6$, $g_6$(D) = 1 + $D^2$ + $D^3$ + $D^4$ + $D^6$ and $g_7$(D) = 1 + $D^1$ + $D^4$ + $D^6$ are used to perform the convolutional encoding, to obtain the T= 8 component code output bit sequences.

In some embodiments, the T component code generation polynomials used in the convolutional encoding further include at least one of: 1 + $D^1$ + $D^3$ + $D^4$ + $D^6$, 1 + $D^2$ + $D^4$ + $D^5$ + $D^6$ and 1 + $D^1$ + $D^4$ + $D^6$. The octal numbers corresponding to the respective component code generation polynomials respectively are 155, 127, and 145. When binary representation is used, the respective component code generation vectors are corresponding to {1, 1, 0, 1, 1, 0, 1}, {1, 0, 1, 0, 1, 1, 1}, and {1, 1, 0, 0, 1, 0, 1}.

In addition, the information bit sequence is $b_0$, $b_1$, $b_2$, $b_3$, ..., $b_{K-1}$, K is the length of the information bit sequence, and the specific process of performing the convolutional encoding based on the component code generation polynomials determined in the above examples may refer to the specific description of the convolutional encoding process in the above implementation 1, which will not be repeated herein.

Implementation 3

A value of the constraint length for the convolutional encoding is 7, in this case, the number of shift registers required may be 7-1=6, and the highest power of the preset component code generation polynomial group is 6 and the preset component code generation polynomial group includes at least one of following component code generation polynomials:

$$g_0(D) = 1 + D^1 + D^2 + D^3 + D^4 + D^6;$$

$$g_1(D) = 1 + D^2 + D^3 + D^5 + D^6;$$

$$g_2(D) = 1 + D^1 + D^4 + D^6;$$

$$g_3(D) = 1 + D^3 + D^4 + D^5 + D^6;$$

$$g_4(D) = 1 + D^2 + D^4 + D^5 + D^6;$$

$$g_5(D) = 1 + D^1 + D^3 + D^4 + D^5 + D^6;$$

$$g_6(D) = 1 + D^1 + D^2 + D^4 + D^6;$$

$$g_7(D) = 1 + D^1 + D^3 + D^6;$$

$$g_8(D) = 1 + D^2 + D^3 + D^4 + D^5 + D^6;$$

$$g_9(D) = 1 + D^1 + D^3 + D^4 + D^6;$$

$$g_{10}(D) = 1 + D^3 + D^4 + D^5 + D^6;$$

$$g_{11}(D) = 1 + D^2 + D^4 + D^5 + D^6.$$

The octal numbers corresponding to the above component code generation polynomials respectively are 175, 133, 145, 117, 127, 157, 165, 151, 137, 155, 117 and 127. When the binary representation is used, the component code generation vectors respectively are: {1, 1, 1, 1, 1, 0, 1}, {1, 0, 1, 1, 0, 1, 1}, {1, 1, 0, 0, 1, 0, 1}, {1, 0, 0, 1, 1, 1, 1}, {1, 1, 0, 1, 1, 1, 1}, {1, 1, 0, 1, 0, 1}, {1, 1, 0, 1, 0, 1}, {1, 0, 1, 1, 1, 1}, {1, 1, 0, 1, 0, 1}, {1, 0, 1, 1, 1, 1}, {1, 1, 0, 1, 0, 1}, {1, 0, 1, 1, 1, 1} 1, 1, 1} and {1, 0, 1, 0, 1, 1, 1}.

Furthermore, the sending end may determine the T component code generation polynomials for convolutional encoding from the above component code generation polynomial group. Herein, T may be equal to 2, 3, 4, 5, 6, 8, 10, or 12.

In some embodiments, the T component code generation polynomials used in the convolutional encoding include at least the first J component code generation polynomials among the above 12 generation polynomials. Herein, the value of J may be 2, 3, 4, 5, 6, 7, 8, 9, 10, or 12, and J is an integer less than or equal to T.

Exemplarily, the sending end may use 2, 3, 4, 5, 6, 8, 10 or 12 of the above 12 component code generation polynomials to perform the convolutional encoding, to obtain the T component code output bit sequences. For example, at least the above generation polynomials $g_0(D) = 1 + D^1 + D^2 + D^3 + D^4 + D^6$ and $g_1(D) = 1 + D^2 + D^3 + D^5 + D^6$ are used to perform the convolutional encoding, to obtain the T=2 component code output bit sequences, which will not be enumerated one by one.

In some embodiments, the T component code generation polynomials used in the convolutional encoding further include at least one of: $1 + D^1 + D^2 + D^3 + D^4 + D^6$, $1 + D^1 + D^4 + D^6$, $1 + D^2 + D^4 + D^5 + D^6$, $1 + D^1 + D^3 + D^6$, $1 + D^2 + D^3 + D^4 + D^5 + D^6$, $1 + D^1 + D^3 + D^4 + D^6$ and $1 + D^2 + D^4 + D^5 + D^6$. The octal numbers corresponding to respective component code generation polynomials respectively correspond to 175, 145, 127, 151, 137, 155, and 127. When the binary representation is used, the respective component code generation vectors correspond to {1, 1, 1, 1, 1, 0, 1}, {1, 1, 0, 0, 1, 0, 1}, {1, 0, 1, 0, 1, 1, 1}, {1, 1, 0, 1, 0, 0, 1}, {1, 0, 1, 1, 1, 1, 1}, {1, 1, 0, 1, 1, 0, 1}, and {1, 0, 1, 0, 1, 1, 1}.

In addition, the information bit sequence is $b_0$, $b_1$, $b_2$, $b_3$, ..., $b_{K-1}$, K is the length of the information bit sequence, and the specific process of performing the convolutional encoding based on the component code generation polynomials determined in the above examples may refer to the specific description of the convolutional encoding process in the above implementation 1, which will not be repeated herein.

Implementation 4

A value of the constraint length for the convolutional encoding is 7, in this case, the number of shift registers required may be 7-1=6, and the highest power of the preset component code generation polynomial group is 6 and the preset component code generation polynomial group includes at least one of following component code generation polynomials:

$$g_0(D) = 1 + D^1 + D^3 + D^4 + D^6;$$

$$g_1(D) = 1 + D^2 + D^3 + D^4 + D^5 + D^6;$$

$$g_2(D) = 1 + D^2 + D^5 + D^6;$$

$$g_3(D) = 1 + D^1 + D^2 + D^3 + D^6;$$

$$g_4(D) = 1 + D^2 + D^4 + D^5 + D^6;$$

$$g_5(D) = 1 + D^1 + D^2 + D^3 + D^5 + D^6;$$

$$g_6(D) = 1 + D^1 + D^2 + D^4 + D^6;$$

$$g_7(D) = 1 + D^3 + D^5 + D^6;$$

$$g_8(D) = 1 + D^1 + D^2 + D^3 + D^4 + D^6;$$

$$g_9(D) = 1 + D^1 + D^3 + D^4 + D^6;$$

$$g_{10}(D) = 1 + D^3 + D^4 + D^5 + D^6;$$

$$g_{11}(D) = 1 + D^2 + D^4 + D^5 + D^6.$$

The octal numbers corresponding to the above component code generation polynomials respectively are 155, 137, 123, 171, 127, 173, 165, 113, 175, 155, 117 and 127. When binary representation is used, the component code generation vectors respectively are: {1, 1, 0, 1, 1, 0, 1}, {1, 0, 1, 1, 1, 1, 1}, {1, 0, 1, 0, 0, 1, 1}, {1, 1, 1, 1, 0, 0, 1}, {1, 0, 1, 0, 1, 1, 1}, {1, 1, 1, 1, 0, 1, 1}, {1, 1, 1, 0, 1, 0, 1}, {1, 0, 0, 1, 0, 1, 1}, {1, 1, 1, 1, 1, 0, 1}, {1, 1, 0, 1, 1, 0, 1}, {1, 0, 0, 1, 1, 1, 1} and {1, 0, 1, 0, 1, 1, 1}.

Furthermore, the sending end may determine the T component code generation polynomials for convolutional encoding from the above component code generation polynomial group. Herein, T may be equal to 2, 3, 4, 5, 6, 8, 10, or 12.

In some embodiments, the T component code generation polynomials used in the convolutional encoding include at least the first J component code generation polynomials among the above 12 generation polynomials. Herein, the value of J may be 2, 3, 4, 5, 6, 7, 8, 9, 10, or 12, and J is an integer less than or equal to T.

Exemplarily, the sending end may use 2, 3, 4, 5, 6, 8, 10 or 12 of the above 12 component code generation polynomials to perform the convolutional encoding, to obtain the T component code output bit sequences. For example, at least the above generation polynomials $g_0(D) = 1 + D^1 + D^3 + D^4 + D^6$ and $g_1(D) = 1 + D^2 + D^3 + D^4 + D^5 + D^6$ are used to perform the convolutional encoding, to obtain the T=2 component code output bit sequences, which will not be enumerated one by one.

In some embodiments, the T component code generation polynomials used in the convolutional encoding further include at least one of: $1 + D^1 + D^3 + D^4 + D^6$, $1 + D^2 + D^3 + D^4 + D^5 + D^6$, $1 + D^2 + D^4 + D^5 + D^6$, $1 + D^3 + D^5 + D^6$ and $1 + D^1 + D^2 + D^3 + D^4 + D^6$. The octal numbers corresponding to the respective component code generation polynomials respectively correspond to 155, 137, 127, and 175. When the binary representation is used, the respective component code generation vectors correspond to {1, 1, 0, 1, 1, 0, 1}, {1, 0, 1, 1, 1, 1, 1}, {1, 0, 1, 0, 1, 1, 1}, {1, 0, 0, 1, 0, 1, 1} and {1, 1, 1, 1, 1, 0, 1}.

In addition, the information bit sequence is $b_0$, $b_1$, $b_2$, $b_3$, ..., $b_{K-1}$, K is the length of the information bit sequence, and the specific process of performing the convolutional encoding based on the component code generation polynomials determined in the above examples may refer to the specific description of the convolutional encoding process in the above implementation 1, which will not be repeated herein.

Implementation 5

A value of the constraint length for the convolutional encoding is 7, in this case, the number of shift registers required may be 7-1=6, and the highest power of the preset component code generation polynomial group is 6 and the preset component code generation polynomial group includes at least one of following component code generation polynomials:

$$g_0(D)=1+D^1+D^2+D^3+D^6;$$

$$g_1(D)=1+D^1+D^3+D^4+D^6;$$

$$g_2(D)=1+D^2+D^4+D^5+D^6;$$

$$g_3(D)=1+D^3+D^4+D^5+D^6.$$

The octal numbers corresponding to the above component code generation polynomials respectively are 171, 155, 127 and 117. When the binary representation is used, the component code generation vectors respectively are: {1, 1, 1, 1, 0, 0, 1}, {1, 1, 0, 1, 1, 0, 1}, {1, 0, 1, 0, 1, 1, 1}, and {1, 0, 0, 1, 1, 1, 1}.

Furthermore, the sending end may determine the T component code generation polynomial group. Herein, T may be equal to 2, 3, or 4. Exemplarily, if the encoding rate of the convolutional encoding is 1/4, T may be equal to 4, that is, the preset component code generation polynomial group includes 4 component code generation polynomials: $g_0(D) = 1 + D^1 + D^2 + D^3 + D^6$; $g_1(D) = 1 + D^1 + D^3 + D^4 + D^6$; $g_2(D) = 1 + D^2 + D^4 + D^5 + D^6$; $g_3(D) = 1 + D^3 + D^4 + D^5 + D^6$.

In addition the information bit sequence is $b_0$, $b_1$, $b_2$, $b_3$, ..., $b_{K-1}$, K is the length of the information bit sequence, and the specific process of performing the convolutional encoding based on the component code generation polynomials determined in the above examples may refer to the specific description of the convolutional encoding process in the above implementation 1, which will not be repeated herein.

Implementation 6

A value of the constraint length for the convolutional encoding is 9, in this case, the number of shift registers required may be 9-1= 8, and the highest power of the preset component code generation polynomial group is 8 and the preset component code generation polynomial group includes at least one of following component code generation polynomials:

$$g_0(D) = 1 + D^2 + D^3 + D^4 + D^8;$$

$$g_1(D) = 1 + D^1 + D^2 + D^3 + D^5 + D^7 + D^8;$$

$$g_2(D) = 1 + D^1 + D^2 + D^5 + D^6 + D^8;$$

$$g_3(D) = 1 + D^2 + D^4 + D^7 + D^8;$$

$$g_4(D) = 1 + D^1 + D^2 + D^4 + D^5 + D^6 + D^7 + D^8;$$

$$g_5(D) = 1 + D^3 + D^5 + D^6 + D^8;$$

$$g_6(D) = 1 + D^1 + D^2 + D^3 + D^5 + D^7 + D^8;$$

$$g_7(D) = 1 + D^1 + D^2 + D^3 + D^6 + D^8;$$

$$g_8(D) = 1 + D^1 + D^3 + D^5 + D^6 + D^7 + D^8;$$

$$g_9(D) = 1 + D^1 + D^3 + D^4 + D^5 + D^8;$$

$$g_{10}(D) = 1 + D^1 + D^2 + D^3 + D^6 + D^8;$$

$$g_{11}(D) = 1 + D^1 + D^3 + D^5 + D^6 + D^7 + D^8.$$

The octal numbers corresponding to the above component code generation polynomials respectively are 561, 753, 715, 523, 737, 455, 753, 745, 657, 671, 745 and 657. When the binary representation is used, the component code generation vectors respectively are: {1, 0, 1, 1, 1, 0, 0, 0, 1}, {1, 1, 1, 1, 0, 1, 0, 1, 1}, {1, 1, 1, 0, 0, 1, 1, 0, 1}, {1, 0, 1, 0, 1, 0, 0, 1, 1}, {1, 1, 1, 0, 1, 1, 1, 1, 1}, {1, 0, 0, 1, 0, 1, 1, 0, 1}, {1, 1, 1, 1, 0, 1, 0, 1, 1}, {1, 1, 1, 1, 0, 0, 1, 0, 1}, {1, 1, 0, 1, 0, 1, 1, 1, 1}, {1, 1, 0, 1, 1, 1, 0, 0, 1}, {1, 1, 1, 1, 0, 0, 1, 0, 1} and {1, 1, 0, 1, 0, 1, 1, 1, 1}.

Furthermore, the sending end may determine the T component code generation polynomials for convolutional encoding from the above component code generation polynomial group.

In some embodiments, the T component code generation polynomials used in the convolutional encoding include at least the first J component code generation polynomials among the above 12 generation polynomials. Herein, the value of J may be 4, 5, 6, 7, 8, 9, 10, or 12, and J is an integer less than or equal to T.

In an example, the convolutional encoding uses at least 4 of the above 12 generation polynomials for encoding, to obtain T= 4 component code output bit sequences, for example, at least the above generation polynomials $g_0(D) = 1 + D^2 + D^3 + D^4 + D^8$, $g_1(D) = 1 + D^1 + D^2 + D^3 + D^5 + D^7 + D^8$, $g_2(D) = 1 + D^1 + D^2 + D^5 + D^6 + D^8$ and $g_3(D) = 1 + D^2 + D^4 + D^7 + D^8$ are used to perform the convolutional encoding, to obtain the T= 4 component code output bit sequences.

In another example, the convolutional encoding uses at least 6 of the above 12 generation polynomials for encoding, to obtain T= 6 component code output bit sequences, for example, at least the above generation polynomials $g_0(D) = 1 + D^2 + D^3 + D^4 + D^8$, $g_1(D) = 1 + D^1 + D^2 + D^3 + D^5 + D^7 + D^8$, $g_2(D) = 1 + D^1 + D^2 + D^5 + D^6 + D^8$, $g_3(D) = 1 + D^2 + D^4 + D^7 + D^8$, $g_4(D) = 1 + D^1 + D^2 + D^4 + D^5 + D^6 + D^7 + D^8$ and $g_5(D) = 1 + D^3 + D^5 + D^6 + D^8$ are used to perform the convolutional encoding, to obtain the T= 6 component code output bit sequences.

In yet another example, the convolutional encoding uses at least 8 of the above 12 generation polynomials for encoding, to obtain T= 8 component code output bit sequences, for example, at least the above generation polynomials $g_0(D) = 1 + D^2 + D^3 + D^4 + D^8$, $g_1(D) = 1 + D^1 + D^2 + D^3 + D^5 + D^7 + D^8$, $g_2(D) = 1 + D^1 + D^2 + D^5 + D^6 + D^8$, $g_3(D) = 1 + D^2 + D^4 + D^7 + D^8$, $g_4(D) = 1 + D^1 + D^2 + D^4 + D^5 + D^6 + D^7 + D^8$, $g_5(D) = 1 + D^3 + D^5 + D^6 + D^8$, $g_6(D) = 1 + D^1 + D^2 + D^3 + D^5 + D^7 + D^8$ and $g_7(D) = 1 + D^1 + D^2 + D^3 + D^6 + D^8$ are used to perform the convolutional encoding, to obtain the T= 8 component code output bit sequences.

In some embodiments, the T component code generation polynomials used in the convolutional encoding further include at least one of: $1 + D^1 + D^2 + D^5 + D^6 + D^8$, $1 + D^2 + D^4 + D^7 + D^8$, $1 + D^1 + D^2 + D^4 + D^5 + D^6 + D^7 + D^8$, $1 + D^3 + D^5 + D^6 + D^8$, $1 + D^1 + D^2 + D^3 + D^5 + D^7 + D^8$, $1 + D^1 + D^2 + D^3 + D^6 + D^8$, $1 + D^1 + D^3 + D^5 + D^6 + D^7 + D^8$, $1 + D^1 + D^3 + D^4 + D^5 + D^8$, $1 + D^1 + D^2 + D^3 + D^6 + D^8$ and $1 + D^1 + D^3 + D^5 + D^6 + D^7 + D^8$. The octal numbers corresponding to respective component code generation polynomials respectively correspond to 715, 523, 737, 455, 753, 745, 657, 671, 745 and 657. When the binary representation is used, the respective component code generation vectors correspond to {1, 1, 1, 0, 0, 1, 1, 0, 1}, {1, 0, 1, 0, 1, 0, 0, 1, 1}, {1, 1, 1, 0, 1, 1, 1, 1, 1}, {1, 0, 0, 1, 0, 1, 1, 0, 1}, {1, 1, 1, 1, 0, 1, 0, 1, 1}, {1, 1, 1, 1, 0, 0, 1, 0, 1}, {1, 1, 0, 1, 0, 1, 1, 1, 1}, {1, 1, 0, 1, 1, 1, 0, 0, 1}, {1, 1, 1, 1, 0, 0, 1, 0, 1}, {1, 1, 0, 1, 0, 1, 1, 1, 1}. Herein, the value of T may be 2, 3, 4, 5, 6, 7, 8, 10, or 12. In some embodiments, the T component code generation polynomials used in the convolutional encoding include at least the first J component code generation polynomials among the above 12 generation polynomials. Herein, the value of J may be 2, 3, 4, 5, 6, 7, 8, 9, 10, or 12, and J is an integer less than or equal to T.

In addition, the information bit sequence is $b_0$, $b_1$, $b_2$, $b_3$, ..., $b_{K-1}$, K is the length of the information bit sequence, and the specific process of performing the convolutional encoding based on the component code generation polynomials determined in the above examples may refer to the specific description of the convolutional encoding process in the above implementation 1, which will not be repeated herein.

Implementation 7

A value of the constraint length for the convolutional encoding is 9, in this case, the number of shift registers required may be 9-1= 8, and the highest power of the preset component code generation polynomial group is 8 and the preset component code generation polynomial group includes at least one of following component code generation polynomials:

$$g_0(D) = 1 + D^2 + D^3 + D^5 + D^6 + D^7 + D^8;$$

$$g_1(D) = 1 + D^1 + D^3 + D^4 + D^7 + D^8;$$

$$g_2(D) = 1 + D^1 + D^2 + D^5 + D^8;$$

$$g_3(D) = 1 + D^1 + D^2 + D^3 + D^4 + D^6 + D^8;$$

$$g_4(D) = 1 + D^2 + D^4 + D^5 + D^6 + D^8;$$

$$g_5(D) = 1 + D^2 + D^5 + D^6 + D^7 + D^8;$$

$$g_6(D) = 1 + D^1 + D^3 + D^5 + D^6 + D^7 + D^8;$$

$$g_7(D) = 1 + D^3 + D^4 + D^5 + D^7 + D^8;$$

$$g_8(D) = 1 + D^1 + D^2 + D^3 + D^6 + D^8;$$

$$g_9(D) = 1 + D^1 + D^3 + D^5 + D^6 + D^7 + D^8;$$

$$g_{10}(D) = 1 + D^2 + D^3 + D^5 + D^8;$$

$$g_{11}(D) = 1 + D^1 + D^2 + D^3 + D^5 + D^7 + D^8.$$

The octal numbers corresponding to the above component code generation polynomials respectively are 557, 663, 711, 765, 535, 517, 657, 473, 745, 657, 551, 753. When the binary representation is used, the component code generation vectors respectively are: {1, 0, 1, 1, 0, 1, 1, 1, 1}, {1, 1, 0, 1, 1, 0, 0, 1, 1}, {1, 1, 1, 0, 0, 1, 0, 0, 1}, {1, 1, 1, 1, 1, 0, 1, 0, 1}, {1, 0, 1, 0, 1, 1, 1, 0, 1}, {1, 0, 1, 0, 0, 1, 1, 1, 1}, {1, 1, 0, 1, 0, 1, 1, 1, 1}, {1, 0, 0, 1, 1, 1, 0, 1, 1}, {1, 1, 1, 1, 0, 0, 1, 0, 1}, {1, 1, 0, 1, 0, 1, 1, 1, 1}, {1, 0, 1, 1, 0, 1, 0, 0, 1} and {1, 1, 1, 1, 0, 1, 0, 1, 1}.

In some embodiments, the T component code generation polynomials used in the convolutional encoding include at least the first J component code generation polynomials among the above 12 generation polynomials. Herein, the value of J may be 4, 5, 6, 7, 8, 9, 10 or 12, and J is an integer less than or equal to T. Herein, T may be equal to 2, 3, 4, 5, 6, 8, 10, or 12.

In an example, the convolutional encoding uses at least 4 of the above 12 generation polynomials for encoding, to obtain T= 4 component code output bit sequences, for example, at least the above generation polynomials $g_0(D) = 1 + D^2 + D^3 + D^5 + D^6 + D^7 + D^8$, $g_1(D) = 1 + D^1 + D^3 + D^4 + D^7 + D^8$, $g_2(D) = 1 + D^1 + D^2 + D^5 + D^8$ and $g_3(D) = 1 + D^1 + D^2 + D^3 + D^4 + D^6 + D^8$ are used to perform the convolutional encoding, to obtain the T= 4 component code output bit sequences.

In yet another example, the convolutional encoding uses at least 5 of the above 12 generation polynomials for encoding, to obtain T= 5 component code output bit sequences, for example, at least the above generation polynomials $g_0(D) = 1 + D^2 + D^3 + D^5 + D^6 + D^7 + D^8$, $g_1(D) = 1 + D^1 + D^3 + D^4 + D^7 + D^8$, $g_2(D) = 1 + D^1 + D^2 + D^5 + D^8$, $g_3(D) = 1 + D^1 + D^2 + D^3 + D^4 + D^6 + D^8$ and $g_4(D) = 1 + D^2 + D^4 + D^5 + D^6 + D^8$ are used to perform the convolutional encoding, to obtain the T= 5 component code output bit sequences.

In yet another example, the convolutional encoding uses at least 6 of the above 12 generation polynomials for encoding, to obtain T= 6 component code output bit sequences, for example, at least the above generation polynomials $g_0(D) = 1 + D^2 + D^3 + D^5 + D^6 + D^7 + D^8$, $g_1(D) = 1 + D^1 + D^3 + D^4 + D^7 + D^8$, $g_2(D) = 1 + D^1 + D^2 + D^5 + D^8$, $g_3(D) = 1 + D^1 + D^2 + D^3 + D^4 + D^6 + D^8$, $g_4(D) = 1 + D^2 + D^4 + D^5 + D^6 + D^8$ and $g_5(D) = 1 + D^2 + D^5 + D^6 + D^7 + D^8$ are used to perform the convolutional encoding, to obtain the T= 6 component code output bit sequences.

In yet another example, the convolutional encoding uses at least 8 of the above 12 generation polynomials for encoding, to obtain T= 8 component code output bit sequences, for example, at least the above generation polynomials $g_0(D) = 1 + D^2 + D^3 + D^5 + D^6 + D^7 + D^8$, $g_1(D) = 1 + D^1 + D^3 + D^4 + D^7 + D^8$, $g_2(D) = 1 + D^1 + D^2 + D^5 + D^8$, $g_3(D) = 1 + D^1 + D^2 + D^3 + D^4 + D^6 + D^8$, $g_4(D) = 1 + D^2 + D^4 + D^5 + D^6 + D^8$, $g_5(D) = 1 + D^2 + D^5 + D^6 + D^7 + D^8$, $g_6(D) = 1 + D^1 + D^3 + D^5 + D^6 + D^7 + D^8$ and $g_7(D) = 1 + D^3 + D^4 + D^5 + D^7 + D^8$ are used to perform the convolutional encoding, to obtain the T= 8 component code output bit sequences.

In some embodiments, the T component code generation polynomials used in the convolutional encoding further include at least one of: $1 + D^1 + D^2 + D^3 + D^4 + D^6 + D^8$, $1 + D^2 + D^4 + D^5 + D^6 + D^8$, $1 + D^2 + D^5 + D^6 + D^7 + D^8$, $1 + D^1 + D^3 + D^5 + D^6 + D^7 + D^8$, $1 + D^3 + D^4 + D^5 + D^7 + D^8$, $1 + D^1 + D^2 + D^3 + D^6 + D^8$, $1 + D^1 + D^3 + D^5 + D^6 + D^7 + D^8$, $1 + D^2 + D^3 + D^5 + D^8$ and $1 + D^1 + D^2 + D^3 + D^5 + D^7 + D^8$. The octal numbers corresponding to respective component code generation polynomials respectively correspond to 765, 535, 517, 657, 473, 745, 657, 551 and 753. When the binary representation is used, the respective component code generation vectors correspond to {1, 1, 1, 1, 1, 0, 1, 0, 1}, {1, 0, 1, 0, 1, 1, 1, 0, 1}, {1, 0, 1, 0, 0, 1, 1, 1, 1}, {1, 1, 0, 1, 0, 1, 1, 1, 1}, {1, 0, 0, 1, 1, 1, 0, 1, 1}, {1, 1, 1, 1, 0, 0, 1, 0, 1}, {1, 1, 0, 1, 0, 1, 1, 1, 1}, {1, 0, 1, 1, 0, 1, 0, 0, 1} and {1, 1, 1, 1, 0, 1, 0, 1, 1}. Herein, the value of T may be 2, 3, 4, 5, 6, 7, 8, 10 or 12. In some embodiments, the T component code generation polynomials used in the convolutional encoding include at least the first J component code generation polynomials among the above 12 generation polynomials. Herein, the value of J may be 2, 3, 4, 5, 6, 7, 8, 9, 10, or 12, and J is an integer less than or equal to T.

In addition, the information bit sequence is $b_0$, $b_1$, $b_2$, $b_3$, ..., $b_{K-1}$, K is the length of the information bit sequence, and the specific process of performing the convolutional encoding based on the component code generation polynomials determined in the above examples may refer to the specific description of the convolutional encoding process in the above implementation 1, which will not be repeated herein.

Implementation 8

A value of the constraint length for the convolutional encoding is 9, in this case, the number of shift registers required may be 9-1= 8, and the highest power of the preset component code generation polynomial group is 8 and the preset component code generation polynomial group includes at least one of following component code generation polynomials:

$$g_0(D) = 1 + D^3 + D^4 + D^6 + D^8;$$

$$g_1(D) = 1 + D^1 + D^2 + D^3 + D^4 + D^5 + D^8;$$

$$g_2(D) = 1 + D^1 + D^3 + D^4 + D^5 + D^7 + D^8;$$

$$g_3(D) = 1 + D^2 + D^3 + D^6 + D^7 + D^8;$$

$$g_4(D) = 1 + D^2 + D^4 + D^5 + D^6 + D^8;$$

$$g_5(D) = 1 + D^2 + D^5 + D^6 + D^7 + D^8;$$

$$g_6(D) = 1 + D^1 + D^3 + D^5 + D^6 + D^7 + D^8;$$

$$g_7(D) = 1 + D^3 + D^4 + D^5 + D^7 + D^8;$$

$$g_8(D) = 1 + D^2 + D^5 + D^6 + D^7 + D^8;$$

$$g_9(D) = 1 + D^1 + D^2 + D^3 + D^5 + D^7 + D^8;$$

$$g_{10}(D) = 1 + D^3 + D^5 + D^6 + D^8;$$

$$g_{11}(D) = 1 + D^1 + D^2 + D^3 + D^5 + D^7 + D^8.$$

The octal numbers corresponding to the above component code generation polynomials respectively are 465, 771, 673, 547, 535, 517, 657, 473, 517, 753, 455 and 753. When the binary representation is used, the component code generation vectors respectively are: {1, 0, 0, 1, 1, 0, 1, 0, 1}, {1, 1, 1, 1, 1, 1, 0, 0, 1}, {1, 1, 0, 1, 1, 1, 0, 1, 1}, {1, 0, 1, 1, 0, 0, 1, 1, 1}, {1, 0, 1, 0, 1, 1, 1, 0, 1}, {1, 0, 1, 0, 0, 1, 1, 1, 1}, {1, 1, 0, 1, 0, 1, 1, 1, 1}, {1, 0, 0, 1, 1, 1, 0, 1, 1}, {1, 0, 1, 0, 0, 1, 1, 1, 1}, {1, 1, 1, 1, 0, 1, 0, 1, 1}, {1, 0, 0, 1, 0, 1, 1, 0, 1} and {1, 1, 1, 1, 0, 1, 0, 1, 1}.

Furthermore, the sending end may determine the T component code generation polynomials for convolutional encoding from the above component code generation polynomial group. Herein, the value of T may be 2, 3, 4, 5, 6, 7, 8, 10 or 12.

In some embodiments, the T component code generation polynomials used in the convolutional encoding include at least the first J component code generation polynomials among the above 12 generation polynomials. Herein, the value of J may be 4, 5, 6, 7, 8, 9, 10, or 12, and J is an integer less than or equal to T.

In an example, the convolutional encoding uses at least 2 of the above 12 generation polynomials for encoding, to obtain the T=2 component code output bit sequences, for example, at least the above generation polynomials $g_0(D) = 1 + D^3 + D^4 + D^6 + D^8$ and $g_1(D) = 1 + D^1 + D^2 + D^3 + D^4 + D^5 + D^8$ are used to perform the convolutional encoding, to obtain the T=2 component code output bit sequences.

In another example, the convolutional encoding uses at least 3 of the above 12 generation polynomials for encoding, to obtain T= 3 component code output bit sequences, for example, at least the above generation polynomials $g_0(D) = 1 + D^3 + D^4 + D^6 + D^8$, $g_1(D) = 1 + D^1 + D^2 + D^3 + D^4 + D^5 + D^8$ and $g_2(D) = 1 + D^1 + D^3 + D^4 + D^5 + D^7 +$ are used to perform the convolutional encoding, to obtain the T= 3 component code output bit sequences.

In yet another example, the convolutional encoding uses at least 4 of the above 12 generation polynomials for encoding, to obtain T= 4 component code output bit sequences, for example, at least the above generation polynomials $g_0(D) = 1 + D^3 + D^4 + D^6 + D^8$, $g_1(D) = 1 + D^1 + D^2 + D^3 + D^4 + D^5 + D^8$, $g_2(D) = 1 + D^1 + D^3 + D^4 + D^5 + D^7 + D^8$ and $g_3(D) = 1 + D^2 + D^3 + D^6 + D^7 + D^8$ are used to perform the convolutional encoding, to obtain the T= 4 component code output bit sequences.

In yet another example, the convolutional encoding uses at least 5 of the above 12 generation polynomials for encoding, to obtain T= 5 component code output bit sequences, for example, at least the above generation polynomials $g_0$ (D) = 1 + D³ + D⁴ + D⁶ + D⁸, $g_1$(D) = 1 + D¹ + D² + D³ + D⁴ + D⁵ + D⁸, $g_2$(D) = 1 + D¹ + D³ + D⁴ + D⁵ + D⁷ + D⁸, $g_3$(D) = 1 + D² + D³ + D⁶ + D⁷ + D⁸ and $g_4$(D) = 1 + D² + D⁴ + D⁵ + D⁶ + D⁸ are used to perform the convolutional encoding, to obtain the T= 5 component code output bit sequences.

In yet another example, the convolutional encoding uses at least 6 of the above 12 generation polynomials for encoding, to obtain T= 6 component code output bit sequences, for example, at least the above generation polynomials $g_0$ (D) = 1 + D³ + D⁴ + D⁶ + D⁸, $g_1$(D) = 1 + D¹ + D² + D³ + D⁴ + D⁵ + D⁸, $g_2$(D) = 1 + D¹ + D³ + D⁴ + D⁵ + D⁷ + D⁸ $g_3$(D) = 1 + D² + D³ + D⁶ + D⁷ + D⁸, $g_4$(D) = 1 + D² + D⁴ + D⁵ + D⁶ + D⁸ and $g_5$(D) = 1 + D² + D⁵ + D⁶ + D⁷ + D⁸ are used to perform the convolutional encoding, to obtain the T= 6 component code output bit sequences.

In yet another example, the convolutional encoding uses at least 8 of the above 12 generation polynomials for encoding, to obtain T= 8 component code output bit sequences, for example, at least the above generation polynomials $g_0$ (D) = 1 + D³ + D⁴ + D⁶ + D⁸, $g_1$(D) = 1 + D¹ + D² + D³ + D⁴ + D⁵ + D⁸, $g_2$(D) = 1 + D¹ + D³ + D⁴ + D⁵ + D⁷ + D⁸ $g_3$(D) = 1 + D² + D³ + D⁶ + D⁷ + D⁸, $g_4$(D) = 1 + D² + D⁴ + D⁵ + D⁶ + D⁸, $g_5$(D) = 1 + D² + D⁵ + D⁶ + D⁷ + D⁸, $g_6$(D) = 1 + D¹ + D³ + D⁵ + D⁶ + D⁷ + D⁸ and $g_7$(D) = 1 + D³ + D⁴ + D⁵ + D⁷ + D⁸ are used to perform the convolutional encoding, to obtain the T= 8 component code output bit sequences.

In some embodiments, the preset component code generation polynomial group may further include at least one of the following component code generation polynomials:

$$g_0(D) = 1 + D^2 + D^4 + D^5 + D^8;$$

$$g_1(D) = 1 + D^3 + D^4 + D^5 + D^6 + D^7 + D^8;$$

$$g_2(D) = 1 + D^1 + D^3 + D^4 + D^5 + D^7 + D^8;$$

$$g_3(D) = 1 + D^1 + D^2 + D^5 + D^6 + D^8;$$

$$g_4(D) = 1 + D^2 + D^3 + D^4 + D^6 + D^8;$$

$$g_5(D) = 1 + D^1 + D^2 + D^3 + D^6 + D^8;$$

$$g_6(D) = 1 + D^1 + D^2 + D^3 + D^5 + D^7 + D^8;$$

$$g_7(D) = 1 + D^1 + D^3 + D^4 + D^5 + D^8;$$

$$g_8(D) = 1 + D^1 + D^2 + D^3 + D^6 + D^8;$$

$$g_9(D) = 1 + D^1 + D^3 + D^5 + D^6 + D^7 + D^8;$$

$$g_{10}(D) = 1 + D^2 + D^3 + D^5 + D^8;$$

$$g_{11}(D) = 1 + D^1 + D^3 + D^5 + D^6 + D^7 + D^8.$$

The octal numbers corresponding to respective component code generation polynomials respectively correspond to 531, 477, 673, 715, 565, 745, 753, 671, 745, 657, 551 and 657. When the binary representation is used, the respective component code generation vectors correspond to {1, 0, 1, 0, 1, 1, 0, 0, 1}, {1, 0, 0, 1, 1, 1, 1, 1, 1}, {1, 1, 0, 1, 1, 1, 0, 1, 1}, {1, 1, 1, 0, 0, 1, 1, 0, 1}, {1, 0, 1, 1, 1, 0, 1, 0, 1}, {1, 1, 1, 1, 0, 0, 1, 0, 1}, {1, 1, 1, 1, 0, 1, 0, 1, 1}, {1, 1, 0, 1, 1, 1, 0, 0, 1}, {1, 1, 1, 1, 0, 0, 1, 0, 1}, {1, 1, 0, 1, 0, 1, 1, 1, 1}, {1, 0, 1, 1, 0, 1, 0, 0, 1} and {1, 1, 0, 1, 0, 1, 1, 1, 1}. Furthermore, the sending end may determine the T component code generation polynomials for convolutional encoding from the above component code generation polynomial group. Herein, the value of T may be 2, 3, 4, 5, 6, 7, 8, 10 or 12. In some embodiments, the T component code generation polynomials used in the convolutional encoding include at least the first J component code generation polynomials among the above 12 generation polynomials. Herein, the value of J may be 2, 3, 4, 5, 6, 7, 8, 9, 10, or 12, and J is an integer less than or equal to T.

In addition, the information bit sequence is $b_0$, $b_1$, $b_2$, $b_3$, ..., $b_{K-1}$, K is the length of the information bit sequence, and the specific process of performing the convolutional encoding based on the component code generation polynomials determined in the above examples may refer to the specific description of the convolutional encoding process in the above implementation 1, which will not be repeated herein.

Implementation 9

A value of the constraint length for the convolutional encoding is 9, in this case, the number of shift registers required may be 9-1= 8, and the highest power of the preset component code generation polynomial group is 8 and the preset component code generation polynomial group includes at least one of following component code generation polynomials:

$$g_0(D) = 1 + D^2 + D^3 + D^4 + D^8;$$

$$g_1(D) = 1 + D^1 + D^2 + D^3 + D^5 + D^7 + D^8;$$

$$g_2(D) = 1 + D^1 + D^2 + D^5 + D^6 + D^8;$$

$$g_3(D) = 1 + D^2 + D^4 + D^7 + D^8.$$

In some embodiments, if the generation polynomial of the 0-th component code is $g_0(D) = 1 + D^2 + D^3 + D^4 + D^8$, the corresponding component code generation vector represented in binary is {1, 0, 1, 1, 1, 0, 0, 0, 1}, and the corresponding octal number is 561. The generation polynomial of the first component code is $g_1(D) = 1 + D^1 + D^2 + D^3 + D^5 + D^7 + D^8$, and the corresponding component code generation vector represented in binary is {1, 1, 1, 1, 0, 1, 0, 1, 1}, and the corresponding octal number is 753. The generation polynomial of the second component code is $g_2(D) = 1 + D^1 + D^2 + D^5 + D^6 + D^8$, and the corresponding binary representation component code generation vector is {1, 1, 1, 0, 0, 1, 1, 0, 1}, which corresponds to the octal number 715. The third component code generation polynomial is at least one of: $1+D^2+D^5+D^6+D^7+D^8$, $1+D^2+D^4+D^5+D^6+D^7+D^8$, $1+D^3+D^4+D^5+D^6+D^8$, $1+D^2+D^4+D^5+D^6+D^8$, $1+D^2+D^3+D^6+D^7+D^8$, $1+D^2+D^4+D^7+D^8$ or $1+D^1+D^4+D^6+D^8$. That is, the component code generation vector corresponding to the third component code is at least one of: {1, 0, 1, 0, 0, 1, 1, 1, 1}, {1, 0, 1, 0, 1, 1, 1, 1, 1}, {1, 0, 0, 1, 1, 1, 1, 0, 1}, {1, 0, 1, 0, 1, 1, 1, 0, 1}, {1, 0, 1, 1, 0, 0, 1, 1, 1}, {1, 0, 1, 0, 1, 0, 0, 1, 1}, {1, 1, 0, 0, 1, 0, 1, 0, 1}. Correspondingly, the generation polynomial of the component code corresponding to the third component code is at least one of the following octal numbers: 517, 537, 475, 535, 547, 523, and 625.

Furthermore, the sending end may determine the T component code generation polynomials for convolutional encoding from the above component code generation polynomial group. Exemplarily, if the convolutional encoding rate is 1/2, the value of T may be 2; if the convolutional encoding rate is 1/4, the value of T may be 4.

In an example, the convolutional encoding uses at least the above generation polynomials $g_0(D) = 1 + D^2 + D^3 + D^4 + D^8$, $g_1(D) = 1 + D^1 + D^2 + D^3 + D^5 + D^7 + D^8$, $g_2(D) = 1 + D^1 + D^2 + D^5 + D^6 + D^8$ and $g_3(D) = 1 + D^2 + D^4 + D^7 + D^8$ for convolutional encoding, to obtain T= 4 component code output bit sequences. Herein, the octal numbers corresponding to the component code generation polynomials respectively are 561, 753, 715, and 523.

In another example, the convolutional encoding uses at least the above generation polynomials $g_0(D) = 1 + D^2 + D^3 + D^4 + D^8$, $g_1(D) = 1 + D^1 + D^2 + D^3 + D^5 + D^7 + D^8$, $g_2(D) = 1 + D^1 + D^2 + D^5 + D^6 + D^8$ and $g_3(D) = 1 + D^1 + D^4 + D^6 + D^8$ for convolutional encoding, to obtain T= 4 component code output bit sequences. Herein, the octal numbers corresponding to the component code generation polynomials respectively are 561, 753, 715, and 625.

In yet another example, the convolutional encoding uses at least the above generation polynomials $g_0(D) = 1 + D^2 + D^3 + D^4 + D^8$, $g_1(D) = 1 + D^1 + D^2 + D^3 + D^5 + D^7 + D^8$, $g_2(D) = 1 + D^1 + D^2 + D^5 + D^6 + D^8$ and $g_3(D) = 1 + D^2 + D^4 + D^5 + D^6 + D^7 + D^8$ for convolutional encoding, to obtain T=4 component code output bit sequences. Herein, the octal numbers corresponding to the component code generation polynomials respectively are 561, 753, 715, and 537.

In yet another example, the convolutional encoding uses at least the above generation polynomials $g_0(D) = 1 + D^2 + D^3 + D^4 + D^8$, $g_1(D) = 1 + D^1 + D^2 + D^3 + D^5 + D^7 + D^8$, $g_2(D) = 1 + D^1 + D^2 + D^5 + D^6 + D^8$ and $g_3(D) = 1 + D^1 + D^3 + D^6 + D^8$ for convolutional encoding, to obtain T= 4 component code output bit sequences. Herein, the octal numbers corresponding to the component code generation polynomials respectively are 561, 753, 715, and 645.

Implementation 10

A value of the constraint length for the convolutional encoding is 9, in this case, the number of shift registers required may be 9-1=8, the highest power of the preset component code generation polynomial group is 8 and if the generation polynomial of the 0-th component code in the preset component code generation polynomial is $g_0(D) = 1 + D^2 + D^3 + D^5 + D^6 + D^7 + D^8$, and the corresponding component code generation vector represented in binary is {1, 0, 1, 1, 0, 1, 1, 1, 1}, and the corresponding octal number is 557. The generation polynomial of the first component code is $g_1(D) = 1 + D^1 + D^3 + D^4 + D^7 + D^8$, and the corresponding component code generation vector represented in binary is {1, 1, 0, 1, 1, 0, 0, 1, 1}, and the corresponding octal number is 663. The generation polynomial of the second component code is $g_2(D) = 1 + D^1 + D^2 + D^5 + D^8$, and the corresponding component code generation vector represented in binary is {1, 1, 1, 0, 0, 1, 0, 0, 1}, and the corresponding octal number is 711. The generation polynomial of the third component code is at least one of: $1+D^1+D^2+D^3+D^4+D^6+D^8$, $1+D^1+D^2+D^4+D^6+D^8$, $1+D^2+D^4+D^5+D^6+D^8$, $1+D^3+D^4+D^5+D^6+D^8$, $1+D^2+D^3+D^4+D^5+D^6+D^8$, $1+D^4+D^5+D^6+D^8$. Correspondingly, the component code generation vector corresponding to the third component code is at least one of: {1, 1, 1, 1, 1, 0, 1, 0, 1}, {1, 1, 1, 0, 1, 0, 1, 0, 1}, {1, 0, 1, 0, 1, 1, 1, 0, 1}, {1, 0, 0, 1, 1, 1, 1, 0, 1}, {1, 0, 1, 1, 1, 1, 1, 0, 1} and {1, 0, 0, 0, 1, 1, 1, 0, 1}. And, the generation polynomial of the component code corresponding to the third component code is at least one of the following octal numbers: 765, 725, 535, 475, 575 and 435.

Furthermore, the sending end may determine the T component code generation polynomials for convolutional encoding from the above component code generation polynomial group. Exemplarily, if the convolutional encoding rate is 1/2, the value of T may be 2; if the convolutional encoding rate is 1/4, the value of T may be 4.

In an example, the convolutional encoding uses at least the above generation polynomials $g_0(D) = 1 + D^2 + D^3 + D^5 + D^6 + D^7 + D^8$, $g_1(D) = 1 + D^1 + D^3 + D^4 + D^7 + D^8$, $g_2(D) = 1 + D^1 + D^2 + D^5 + D^8$ and $g_3(D) = 1 + D^1 + D^2 + D^3 + D^4 + D^6 + D^8$ for convolutional encoding, to obtain T = 4 component code output bit sequences. Herein, the octal numbers corresponding to the component code generation polynomials respectively are 557, 663, 711 and 765.

Implementation 11

A value of the constraint length for the convolutional encoding is 5, in this case, the number of shift registers required may be 5-1= 4, and the highest power of the preset component code generation polynomial group is 4 and the preset component code generation polynomial group includes at least one of following component code generation polynomials:

$$g_0(D) = 1 + D^3 + D^4;$$

$$g_1(D) = 1 + D^1 + D^2 + D^4;$$

$$g_2(D) = 1 + D^2 + D^3 + D^4;$$

$$g_3(D) = 1 + D^1 + D^3 + D^4;$$

$$g_4(D) = 1 + D^1 + D^2 + D^4;$$

$$g_5(D) = 1 + D^2 + D^3 + D^4;$$

$$g_6(D) = 1 + D^1 + D^2 + D^4;$$

$$g_7(D) = 1 + D^2 + D^3 + D^4;$$

$$g_8(D) = 1 + D^1 + D^2 + D^3 + D^4;$$

$$g_9(D) = 1 + D^2 + D^3 + D^4;$$

$$g_{10}(D) = 1 + D^1 + D^2 + D^4;$$

$$g_{11}(D) = 1 + D^2 + D^3 + D^4.$$

The octal numbers corresponding to the above component code generation polynomials respectively are 23, 35, 27, 33, 35, 27, 35, 27, 37, 27, 35 and 27. When the binary representation is used, the component code generation vectors respectively are: {1, 0, 0, 1, 1}, {1, 1, 1, 0, 1}, {1, 0, 1, 1, 1}, {1, 1, 0, 1, 1}, {1, 1, 1, 0, 1}, {1, 0, 1, 1, 1}, {1, 1, 1, 0, 1}, {1, 0, 1, 1, 1}, {1, 1, 1, 1, 1}, {1, 0, 1, 1, 1}, {1, 1, 1, 0, 1} and {1, 0, 1, 1, 1}.

Furthermore, the sending end may determine the T component code generation polynomials for convolutional encoding from the above component code generation polynomial group.

In some embodiments, the T component code generation polynomials used in the convolutional encoding include at least the first J component code generation polynomials among the above 12 generation polynomials. Herein, the value of J may be 4, 5, 6, 7, 8, 9, 10 or 12, and J is an integer less than or equal to T.

In an example, the convolutional encoding uses at least 2 of the above 12 generation polynomials for encoding, to obtain the T=2 component code output bit sequences, for example, at least the above generation polynomials $g_0(D) = 1 + D^3 + D^4$ and $g_1(D) = 1 + D^1 + D^2 + D^4$ are used to perform convolutional encoding, to obtain the T=2 component code output bit sequences.

In another example, the convolutional encoding uses at least 3 of the above 12 generation polynomials for encoding, to obtain T=3 component code output bit sequences, for example, at least the above generation polynomials $g_0(D) = 1 + D^3 + D^4$, $g_1(D) = 1 + D^1 + D^2 + D^4$ and $g_2(D) = 1 + D^2 + D^3 + D^4$ are used to perform convolutional encoding, to obtain the T=3 component code output bit sequences.

In yet another example, the convolutional encoding uses at least 4 of the above 12 generation polynomials for encoding, to obtain T= 4 component code output bit sequences, for example, at least the above generation polynomials $g_0(D) = 1 + D^3 + D^4$, $g_1(D) = 1 + D^1 + D^2 + D^4$, $g_2(D) = 1 + D^2 + D^3 + D^4$ and $g_3(D) = 1 + D^1 + D^3 + D^4$ are used to perform the convolutional encoding, to obtain the T= 4 component code output bit sequences.

In yet another example, the convolutional encoding uses at least 5 of the above 12 generation polynomials for encoding, to obtain T= 5 component code output bit sequences, for example, at least the above generation polynomials $g_0(D) = 1 + D^3 + D^4$, $g_1(D) = 1 + D^1 + D^2 + D^4$, $g_2(D) = 1 + D^2 + D^3 + D^4$, $g_3(D) = 1 + D^1 + D^3 + D^4$ and $g_4(D) = 1 + D^1 + D^2 + D^4$ are used to perform the convolutional encoding, to obtain the T= 5 component code output bit sequences.

In yet another example, the convolutional encoding uses at least 6 of the above 12 generation polynomials for encoding, to obtain T= 6 component code output bit sequences, for example, at least the above generation polynomials $g_0(D) = 1 + D^3 + D^4$, $g_1(D) = 1 + D^1 + D^2 + D^4$ $g_2(D) = 1 + D^2 + D^3 + D^4$ $g_3(D) = 1 + D^1 + D^3 + D^4$ $g_4(D) = 1 + D^1 + D^2 + D^4$ and $g_5(D) = 1 + D^2 + D^3 + D^4$ are used to perform the convolutional encoding, to obtain the T= 6 component code output bit sequences.

In yet another example, the convolutional encoding uses at least 8 of the above 12 generation polynomials for encoding, to obtain T= 8 component code output bit sequences, for example, at least the above generation polynomials $g_0(D) = 1 + D^3 + D^4$, $g_1(D) = 1 + D^1 + D^2 + D^4$ $g_2(D) = 1 + D^2 + D^3 + D^4$ $g_3(D) = 1 + D^1 + D^3 + D^4$ $g_4(D) = 1 + D^1 + D^2 + D^4$, $g_5(D) = 1 + D^2 + D^3 + D^4$, $g_6(D) = 1 + D^1 + D^2 + D^4$ and $g_7(D) = 1 + D^2 + D^3 + D^4$ are used to perform the convolutional encoding, to obtain the T= 8 component code output bit sequences.

In some embodiments, the preset component code generation polynomial group may further include at least one of the following component code generation polynomials:

$$g_0(D) = 1 + D^1 + D^4;$$

$$g_1(D) = 1 + D^2 + D^3 + D^4;$$

$$g_2(D) = 1 + D^1 + D^2 + D^4;$$

$$g_3(D) = 1 + D^1 + D^3 + D^4;$$

$$g_4(D) = 1 + D^1 + D^2 + D^4;$$

$$g_5(D) = 1 + D^2 + D^3 + D^4;$$

$$g_6(D) = 1 + D^1 + D^2 + D^4;$$

$$g_7(D) = 1 + D^2 + D^3 + D^4;$$

$$g_8(D) = 1 + D^1 + D^2 + D^3 + D^4;$$

$$g_9(D) = 1 + D^2 + D^3 + D^4;$$

$$g_{10}(D) = 1 + D^1 + D^2 + D^4;$$

$$g_{11}(D) = 1 + D^2 + D^3 + D^4.$$

The octal numbers corresponding to respective component code generation polynomials respectively correspond to 31, 27, 35, 33, 35, 27, 35, 27, 37, 27, 35 and 27. When the binary representation is used, the respective component code generation vectors correspond to $\{1, 1, 0, 0, 1\}$, $\{1, 0, 1, 1, 1\}$, $\{1, 1, 1, 0, 1\}$, $\{1, 1, 0, 1, 1\}$, $\{1, 1, 1, 0, 1\}$, $\{1, 0, 1, 1, 1\}$, $\{1, 1, 1, 0, 1\}$, $\{1, 0, 1, 1, 1\}$, $\{1, 1, 1, 1, 1\}$, $\{1, 0, 1, 1, 1\}$, $\{1, 1, 1, 0, 1\}$ and $\{1, 0, 1, 1, 1\}$. Furthermore, the sending end may determine the T component code generation polynomials for convolutional encoding from the above component code generation polynomial group. In some embodiments, the T component code generation polynomials used in the convolutional encoding include at least the first J component code generation polynomials among the above 12 generation polynomials. Herein, the value of J may be 4, 5, 6, 7, 8, 9, 10 or 12, and J is an integer less than or equal to T.

In an example, the convolutional encoding uses at least 2 of the above 12 generation polynomials for encoding, to obtain the T=2 component code output bit sequences, for example, at least the above generation polynomials $g_0(D) = 1 + D^1 + D^4$ and $g_1(D) = 1 + D^2 + D^3 + D^4$ are used to perform convolutional encoding, to obtain the T=2 component code output bit sequences.

In another example, the convolutional encoding uses at least 3 of the above 12 generation polynomials for encoding, to obtain T=3 component code output bit sequences, for example, at least the above generation polynomials $g_0(D) = 1 + D^1 + D^4$, $g_1(D) = 1 + D^2 + D^3 + D^4$ and $g_2(D) = 1 + D^1 + D^2 + D^4$ are used to perform convolutional encoding, to obtain the T=3 component code output bit sequences.

In yet another example, the convolutional encoding uses at least 4 of the above 12 generation polynomials for encoding, to obtain T=4 component code output bit sequences, for example, at least the above generation polynomials $g_0(D) = 1 + D^1 + D^4$, $g_1(D) = 1 + D^2 + D^3 + D^4$, $g_2(D) = 1 + D^1 + D^2 + D^4$ and $g_3(D) = 1 + D^1 + D^3 + D^4$ are used to perform the convolutional encoding, to obtain the T= 4 component code output bit sequences.

In yet another example, the convolutional encoding uses at least 5 of the above 12 generation polynomials for encoding, to obtain T=5 component code output bit sequences, for example, at least the above generation polynomials $g_0(D) = 1 + D^1 + D^4$, $g_1(D) = 1 + D^2 + D^3 + D^4$, $g_2(D) = 1 + D^1 + D^2 + D^4$, $g_3(D) = 1 + D^1 + D^3 + D^4$ and $g_4(D) = 1 + D^1 + D^2 + D^4$ are used to perform the convolutional encoding, to obtain the T= 5 component code output bit sequences.

In yet another example, the convolutional encoding uses at least 6 of the above 12 generation polynomials for encoding, to obtain T= 6 component code output bit sequences, for example, at least the above generation polynomials $g_0(D) = 1 + D^1 + D^4$, $g_1(D) = 1 + D^2 + D^3 + D^4$, $g_2(D) = 1 + D^1 + D^2 + D^4$, $g_3(D) = 1 + D^1 + D^3 + D^4$ $g_4(D) = 1 + D^1 + D^2 + D^4$ and $g_5(D) = 1 + D^2 + D^3 + D^4$ are used to perform the convolutional encoding, to obtain the T= 6 component code output bit sequences.

In yet another example, the convolutional encoding uses at least 8 of the above 12 generation polynomials for encoding, to obtain T= 8 component code output bit sequences, for example, at least the above generation polynomials $g_0(D) = 1 + D^1 + D^4$, $g_1(D) = 1 + D^2 + D^3 + D^4$, $g_2(D) = 1 + D^1 + D^2 + D^4$, $g_3(D) = 1 + D^1 + D^3 + D^4$, $g_4(D) = 1 + D^1 + D^2 + D^4$, $g_5(D) = 1 + D^2 + D^3 + D^4$, $g_6(D) = 1 + D^1 + D^2 + D^4$ and $g_7(D) = 1 + D^2 + D^3 + D^4$ are used to perform the convolutional encoding, to obtain the T= 8 component code output bit sequences.

Implementation 12

A value of the constraint length for the convolutional encoding is 6, in this case, the number of shift registers required may be 6-1= 5, and the highest power of the preset component code generation polynomial group is 5 and the preset component code generation polynomial group includes at least one of following component code generation polynomials:

$$g_0(D) = 1 + D^2 + D^4 + D^5;$$

$$g_1(D) = 1 + D^1 + D^2 + D^3 + D^5;$$

$$g_2(D) = 1 + D^3 + D^4 + D^5;$$

$$g_3(D) = 1 + D^1 + D^3 + D^4 + D^5;$$

$$g_4(D) = 1 + D^2 + D^3 + D^4 + D^5;$$

$$g_5(D) = 1 + D^1 + D^3 + D^5;$$

$$g_6(D) = 1 + D^1 + D^2 + D^3 + D^5;$$

$$g_7(D) = 1 + D^1 + D^2 + D^5;$$

$$g_8(D) = 1 + D^2 + D^4 + D^5;$$

$$g_9(D) = 1 + D^2 + D^3 + D^4 + D^5;$$

$$g_{10}(D) = 1 + D^1 + D^2 + D^3 + D^5;$$

$$g_{11}(D) = 1 + D^1 + D^3 + D^4 + D^5.$$

The octal numbers corresponding to the above component code generation polynomials respectively are 53, 75, 47, 67, 57, 65, 75, 71, 53, 57, 75 and 67. When the binary representation is used, the component code generation vectors respectively are: {1, 0, 1, 0, 1, 1}, {1, 1, 1, 1, 0, 1}, {1, 0, 0, 1, 1, 1}, {1, 1, 0, 1, 1, 1}, {1, 0, 1, 1, 1, 1}, {1, 1, 0, 1, 0, 1}, {1, 1, 1, 1, 0, 1}, {1, 1, 1, 0, 0, 1}, {1, 0, 1, 0, 1, 1}, {1, 0, 1, 1, 1, 1}, {1, 1, 1, 1, 0, 1} and {1, 1, 0, 1, 1, 1}.

Furthermore, the sending end may determine the T component code generation polynomials for convolutional encoding from the above component code generation polynomial group. The value of T may be 2, 3, 4, 5, 6, 7, 8, 10 or 12.

In some embodiments, the T component code generation polynomials used in the convolutional encoding include at least the first J component code generation polynomials among the above 12 generation polynomials. Herein, the value of J may be 4, 5, 6, 7, 8, 9, 10, or 12, and J is an integer less than or equal to T.

In an example, the convolutional encoding uses at least 2 of the above 12 generation polynomials for encoding, to obtain the T=2 component code output bit sequences, for example, at least the above generation polynomials $g_0(D) = 1 + D^2 + D^4 + D^5$ and $g_1(D) = 1 + D^1 + D^2 + D^3 + D^5$ are used to perform convolutional encoding, to obtain the T=2 component code output bit sequences.

In another example, the convolutional encoding uses at least 3 of the above 12 generation polynomials for encoding, to obtain T=3 component code output bit sequences, for example, at least the above generation polynomials $g_0(D) = 1 + D^2 + D^4 + D^5$, $g_1(D) = 1 + D^1 + D^2 + D^3 + D^5$ and $g_2(D) = 1 + D^3 + D^4 + D^5$ are used to perform convolutional encoding, to obtain the T=3 component code output bit sequences.

In yet another example, the convolutional encoding uses at least 4 of the above 12 generation polynomials for encoding, to obtain T= 4 component code output bit sequences, for example, at least the above generation polynomials $g_0(D) = 1 + D^2 + D^4 + D^5$, $g_1(D) = 1 + D^1 + D^2 + D^3 + D^5$, $g_2(D) = 1 + D^3 + D^4 + D^5$ and $g_3(D) = 1 + D^1 + D^3 + D^4 + D^5$ are used to perform the convolutional encoding, to obtain the T= 4 component code output bit sequences.

In yet another example, the convolutional encoding uses at least 5 of the above 12 generation polynomials for encoding, to obtain T= 5 component code output bit sequences, for example, at least the above generation polynomials $g_0(D) = 1 + D^2 + D^4 + D^5$, $g_1(D) = 1 + D^1 + D^2 + D^3 + D^5$, $g_2(D) = 1 + D^3 + D^4 + D^5$, $g_3(D) = 1 + D^1 + D^3 + D^4 + D^5$ and $g_4(D) = 1 + D^2 + D^3 + D^4 + D^5$ are used to perform the convolutional encoding, to obtain the T= 5 component code output bit sequences.

In yet another example, the convolutional encoding uses at least 6 of the above 12 generation polynomials for encoding, to obtain T= 6 component code output bit sequences, for example, at least the above generation polynomials $g_0$(D) = $1 + D^2 + D^4 + D^5$, $g_1$(D) = $1 + D^1 + D^2 + D^3 + D^5$, $g_2$(D) = $1 + D^3 + D^4 + D^5$, $g_3$(D) = $1 + D^1 + D^3 + D^4 + D^5$, $g_4$(D) = $1 + D^2 + D^3 + D^4 + D^5$ and $g_5$(D) = $1 + D^1 + D^3 + D^5$ are used to perform the convolutional encoding, to obtain the T= 6 component code output bit sequences.

In yet another example, the convolutional encoding uses at least 8 of the above 12 generation polynomials for encoding, to obtain T= 8 component code output bit sequences, for example, at least the above generation polynomials $g_0$(D) = $1 + D^2 + D^4 + D^5$, $g_1$(D) = $1 + D^1 + D^2 + D^3 + D^5$, $g_2$(D) = $1 + D^3 + D^4 + D^5$, $g_3$(D) = $1 + D^1 + D^3 + D^4 + D^5$, $g_4$(D) = $1 + D^2 + D^3 + D^4 + D^5$, $g_5$(D) = $1 + D^1 + D^3 + D^5$, $g_5$(D) = $1 + D^1 + D^2 + D^3 + D^5$ and $g_7$(D) = $1 + D^1 + D^2 + D^5$ are used to perform the convolutional encoding, to obtain the T= 8 component code output bit sequences.

In addition, the information bit sequence is $b_0$, $b_1$, $b_2$, $b_3$, ..., $b_{K-1}$, K is the length of the information bit sequence, and the specific process of performing the convolutional encoding based on the component code generation polynomials determined in the above examples may refer to the specific description of the convolutional encoding process in the above implementation 1, which will not be repeated herein.

In some embodiments, the preset component code generation polynomial group may further include at least one of the following component code generation polynomials:

$$g_0(D) = 1 + D^1 + D^3 + D^5;$$

$$g_1(D) = 1 + D^2 + D^3 + D^4 + D^5;$$

$$g_2(D) = 1 + D^1 + D^2 + D^5;$$

$$g_3(D) = 1 + D^1 + D^2 + D^4 + D^5;$$

$$g_4(D) = 1 + D^1 + D^2 + D^3 + D^5;$$

$$g_5(D) = 1 + D^2 + D^4 + D^5;$$

$$g_6(D) = 1 + D^2 + D^3 + D^4 + D^5;$$

$$g_7(D) = 1 + D^3 + D^4 + D^5;$$

$$g_8(D) = 1 + D^1 + D^3 + D^5;$$

$$g_9(D) = 1 + D^2 + D^3 + D^4 + D^5;$$

$$g_{10}(D) = 1 + D^1 + D^2 + D^3 + D^5;$$

$$g_{11}(D) = 1 + D^1 + D^2 + D^4 + D^5.$$

The octal numbers corresponding to the above respective component code generation polynomials respectively correspond to 65, 57, 71, 73, 75, 53, 57, 47, 65, 57, 75 and 73. When the binary representation is used, the respective component code generation vectors correspond to {1, 1, 0, 1, 0, 1}, {1, 0, 1, 1, 1, 1}, {1, 1, 1, 0, 0, 1}, {1, 1, 1, 0, 1, 1}, {1, 1, 1, 1, 0, 1}, {1, 0, 1, 0, 1, 1}, {1, 0, 1, 1, 1, 1}, {1, 0, 0, 1, 1, 1}, {1, 1, 0, 1, 0, 1}, {1, 0, 1, 1, 1, 1}, {1, 1, 1, 1, 0, 1} and {1, 1, 1, 0, 1, 1}. Furthermore, the sending end may determine the T component code generation polynomials for convolutional encoding from the above component code generation polynomial group. In some embodiments, the T component code generation polynomials used in the convolutional encoding include at least the first J component code generation polynomials among the above 12 generation polynomials. Herein, the value of J may be 4, 5, 6, 7, 8, 9, 10 or 12, and J is an integer less than or equal to T.

Implementation 13

A value of the constraint length for the convolutional encoding is 8, in this case, the number of shift registers required may be 8-1= 7, and the highest power of the preset component code generation polynomial group is 7 and the preset component code generation polynomial group includes at least one of following component code generation polynomials:

$$g_0(D) = 1 + D^2 + D^4 + D^5 + D^7;$$

$$g_1(D) = 1 + D^1 + D^2 + D^3 + D^6 + D^7;$$

$$g_2(D) = 1 + D^3 + D^5 + D^6 + D^7;$$

$$g_3(D) = 1 + D^1 + D^3 + D^4 + D^5 + D^6 + D^7;$$

$$g_4(D) = 1 + D^1 + D^2 + D^4 + D^7;$$

$$g_5(D) = 1 + D^2 + D^3 + D^4 + D^5 + D^7;$$

$$g_6(D) = 1 + D^1 + D^2 + D^4 + D^6 + D^7;$$

$$g_7(D) = 1 + D^2 + D^5 + D^6 + D^7;$$

$$g_8(D) = 1 + D^1 + D^3 + D^5 + D^6 + D^7;$$

$$g_9(D) = 1 + D^1 + D^2 + D^5 + D^7;$$

$$g_{10}(D) = 1 + D^1 + D^2 + D^3 + D^4 + D^6 + D^7;$$

$$g_{11}(D) = 1 + D^2 + D^5 + D^6 + D^7.$$

The octal numbers corresponding to the above component code generation polynomials respectively are 255, 363, 227, 337, 351, 275, 353, 247, 327, 345, 373 and 247. When the binary representation is used, the component code generation vectors respectively are: {1, 0, 1, 0, 1, 1, 0, 1}, {1, 1, 1, 1, 0, 0, 1, 1}, {1, 0, 0, 1, 0, 1, 1, 1}, {1, 1, 0, 1, 1, 1, 1, 1}, {1, 1, 1, 0, 1, 0, 0, 1}, {1, 0, 1, 1, 1, 1, 0, 1}, {1, 1, 1, 0, 1, 0, 1, 1}, {1, 0, 1, 0, 0, 1, 1, 1}, {1, 1, 0, 1, 0, 1, 1, 1}, {1, 1, 1, 0, 0, 1, 0, 1}, {1, 1, 1, 1, 1, 0, 1, 1} and {1, 0, 1, 0, 0, 1, 1, 1}.

Furthermore, the sending end may determine the T component code generation polynomials for convolutional encoding from the above component code generation polynomial group. The value of T may be 2, 3, 4, 5, 6, 7, 8, 10 or 12.

In some embodiments, the T component code generation polynomials used in the convolutional encoding include at least the first J component code generation polynomials among the above 12 generation polynomials. Herein, the value of J may be 4, 5, 6, 7, 8, 9, 10 or 12, and J is an integer less than or equal to T.

In an example, the convolutional encoding uses at least 2 of the above 12 generation polynomials for encoding, to obtain the T=2 component code output bit sequences, for example, at least the above generation polynomials $g_0(D) = 1 + D^2 + D^4 + D^5 + D^7$ and $g_1(D) = 1 + D^1 + D^2 + D^3 + D^6 + D^7$ are used to perform the convolutional encoding, to obtain the T=2 component code output bit sequences.

In another example, the convolutional encoding uses at least 3 of the above 12 generation polynomials for encoding, to obtain T= 3 component code output bit sequences, for example, at least the above generation polynomials $g_0$

(D) = 1 + $D^2$ + $D^4$ + $D^5$ + $D^7$, $g_1$(D) = 1 + $D^1$ + $D^2$ + $D^3$ + $D^6$ + $D^7$ and $g_2$(D) = 1 + $D^3$ + $D^5$ + $D^6$ + $D^7$ are used to perform the convolutional encoding, to obtain the T= 3 component code output bit sequences.

In yet another example, the convolutional encoding uses at least 4 of the above 12 generation polynomials for encoding, to obtain T=4 component code output bit sequences, for example, at least the above generation polynomials $g_0$(D) = 1 + $D^2$ + $D^4$ + $D^5$ + $D^7$, $g_1$(D) = 1 + $D^1$ + $D^2$ + $D^3$ + $D^6$ + $D^7$ and $g_2$(D) = 1 + $D^3$ + $D^5$ + $D^6$ + $D^7$ are used to perform the convolutional encoding, to obtain the T=4 component code output bit sequences.

In yet another example, the convolutional encoding uses at least 5 of the above 12 generation polynomials for encoding, to obtain T= 5 component code output bit sequences, for example, at least the above generation polynomials $g_0$(D) = 1 + $D^2$ + $D^4$ + $D^5$ + $D^7$, $g_1$(D) = 1 + $D^1$ + $D^2$ + $D^3$ + $D^6$ + $D^7$, $g_2$(D) = 1 + $D^3$ + $D^5$ + $D^6$ + $D^7$, $g_3$(D) = 1 + $D^1$ + $D^3$ + $D^4$ + $D^5$ + $D^6$ + $D^7$ and $g_4$(D) = 1 + $D^1$ + $D^2$ + $D^4$ + $D^7$ are used to perform the convolutional encoding, to obtain the T= 5 component code output bit sequences.

In yet another example, the convolutional encoding uses at least 6 of the above 12 generation polynomials for encoding, to obtain T= 6 component code output bit sequences, for example, at least the above generation polynomials $g_0$(D) = 1 + $D^2$ + $D^4$ + $D^5$ + $D^7$, $g_1$(D) = 1 + $D^1$ + $D^2$ + $D^3$ + $D^6$ + $D^7$, $g_2$(D) = 1 + $D^3$ + $D^5$ + $D^6$ + $D^7$, $g_3$(D) = 1 + $D^1$ + $D^3$ + $D^4$ + $D^5$ + $D^6$ + $D^7$, $g_4$(D) = 1 + $D^1$ + $D^2$ + $D^4$ + $D^7$ and $g_5$(D) = 1 + $D^2$ + $D^3$ + $D^4$ + $D^5$ + $D^7$ are used to perform the convolutional encoding, to obtain the T= 6 component code output bit sequences.

In yet another example, the convolutional encoding uses at least 8 of the above 12 generation polynomials for encoding, to obtain T= 8 component code output bit sequences, for example, at least the above generation polynomials $g_0$(D) = 1 + $D^2$ + $D^4$ + $D^5$ + $D^7$, $g_1$(D) = 1 + $D^1$ + $D^2$ + $D^3$ + $D^6$ + $D^7$, $g_2$(D) = 1 + $D^3$ + $D^5$ + $D^6$ + $D^7$, $g_3$(D) = 1 + $D^1$ + $D^3$ + $D^4$ + $D^5$ + $D^6$ + $D^7$, $g_4$(D) = 1 + $D^1$ + $D^2$ + $D^4$ + $D^7$, $g_5$(D) = 1 + $D^2$ + $D^3$ + $D^4$ + $D^5$ + $D^7$, $g_6$(D) = 1 + $D^1$ + $D^2$ + $D^4$ + $D^6$ + $D^7$ and $g_7$(D) = 1 + $D^2$ + $D^5$ + $D^6$ + $D^7$ are used to perform the convolutional encoding, to obtain the T= 8 component code output bit sequences.

In addition, the information bit sequence is $b_0$, $b_1$, $b_2$, $b_3$, ..., $b_{K-1}$, K is the length of the information bit sequence, and the specific process of performing the convolutional encoding based on the component code generation polynomials determined in the above examples may refer to the specific description of the convolutional encoding process in the above implementation 1, which will not be repeated herein.

In some embodiments, the preset component code generation polynomial group may further include at least one of the following component code generation polynomials:

$$g_0(D) = 1 + D^2 + D^3 + D^5 + D^7;$$

$$g_1(D) = 1 + D^1 + D^4 + D^5 + D^6 + D^7;$$

$$g_2(D) = 1 + D^1 + D^2 + D^4 + D^7;$$

$$g_3(D) = 1 + D^1 + D^2 + D^3 + D^4 + D^6 + D^7;$$

$$g_4(D) = 1 + D^3 + D^5 + D^6 + D^7;$$

$$g_5(D) = 1 + D^2 + D^3 + D^4 + D^5 + D^7;$$

$$g_6(D) = 1 + D^1 + D^3 + D^5 + D^6 + D^7;$$

$$g_7(D) = 1 + D^1 + D^2 + D^5 + D^7;$$

$$g_8(D) = 1 + D^1 + D^2 + D^4 + D^6 + D^7;$$

$$g_9(D) = 1 + D^2 + D^5 + D^6 + D^7;$$

$$g_{10}(D) = 1 + D^1 + D^3 + D^4 + D^5 + D^6 + D^7;$$

$$g_{11}(D) = 1 + D^1 + D^2 + D^5 + D^7.$$

The octal numbers corresponding to the above respective component code generation polynomials respectively correspond to 265, 317, 351, 373, 227, 275, 327, 345, 353, 247, 337 and 345. When the binary representation is used, the respective component code generation vectors correspond to {1, 0, 1, 1, 0, 1, 0, 1}, {1, 1, 0, 0, 1, 1, 1, 1}, {1, 1, 1, 0, 1, 0, 0, 1}, {1, 1, 1, 1, 1, 0, 1, 1}, {1, 0, 0, 1, 0, 1, 1, 1}, {1, 0, 1, 1, 1, 1, 0, 1}, {1, 1, 0, 1, 0, 1, 1, 1}, {1, 1, 1, 0, 0, 1, 0, 1}, {1, 1, 1, 0, 1, 0, 1, 1}, {1, 0, 1, 0, 0, 1, 1, 1}, {1, 1, 0, 1, 1, 1, 1, 1} and {1, 1, 1, 0, 0, 1, 0, 1}.

Furthermore, the sending end may determine the T component code generation polynomials for convolutional encoding from the above component code generation polynomial group. The value of T may be 2, 3, 4, 5, 6, 7, 8, 10 or 12.

In some embodiments, the T component code generation polynomials used in the convolutional encoding include at least the first J component code generation polynomials among the above 12 generation polynomials. Herein, the value of J may be 4, 5, 6, 7, 8, 9, 10 or 12, and J is an integer less than or equal to T.

In an example, the convolutional encoding uses at least 2 of the above 12 generation polynomials for encoding, to obtain the T=2 component code output bit sequences, for example, at least the above generation polynomials $g_0(D) = 1 + D^2 + D^3 + D^5 + D^7$ and $g_1(D) = 1 + D^1 + D^4 + D^5 + D^6 + D^7$ are used to perform the convolutional encoding, to obtain the T=2 component code output bit sequences.

In another example, the convolutional encoding uses at least 3 of the above 12 generation polynomials for encoding, to obtain T= 3 component code output bit sequences, for example, at least the above generation polynomials $g_0(D) = 1 + D^2 + D^3 + D^5 + D^7$, $g_1(D) = 1 + D^1 + D^4 + D^5 + D^6 + D^7$ and $g_2(D) = 1 + D^1 + D^2 + D^4 + D^7$ are used to perform the convolutional encoding, to obtain the T=3 component code output bit sequences.

In yet another example, the convolutional encoding uses at least 4 of the above 12 generation polynomials for encoding, to obtain T=4 component code output bit sequences, for example, at least the above generation polynomials $g_0(D) = 1 + D^2 + D^3 + D^5 + D^7$, $g_1(D) = 1 + D^1 + D^4 + D^5 + D^6 + D^7$, $g_2(D) = 1 + D^1 + D^2 + D^4 + D^7$ and $g_3(D) = 1 + D^1 + D^2 + D^3 + D^4 + D^6 + D^7$ are used to perform the convolutional encoding, to obtain the T=4 component code output bit sequences.

In yet another example, the convolutional encoding uses at least 5 of the above 12 generation polynomials for encoding, to obtain T=5 component code output bit sequences, for example, at least the above generation polynomials $g_0(D) = 1 + D^2 + D^3 + D^5 + D^7$, $g_1(D) = 1 + D^1 + D^4 + D^5 + D^6 + D^7$, $g_2(D) = 1 + D^1 + D^2 + D^4 + D^7$, $g_3(D) = 1 + D^1 + D^2 + D^3 + D^4 + D^6 + D^7$ and $g_4(D) = 1 + D^3 + D^5 + D^6$ are used to perform the convolutional encoding, to obtain the T=5 component code output bit sequences.

In yet another example, the convolutional encoding uses at least 6 of the above 12 generation polynomials for encoding, to obtain T=6 component code output bit sequences, for example, at least the above generation polynomials $g_0(D) = 1 + D^2 + D^3 + D^5 + D^7$, $g_1(D) = 1 + D^1 + D^4 + D^5 + D^6 + D^7$, $g_2(D) = 1 + D^1 + D^2 + D^4 + D^7$, $g_3(D) = 1 + D^1 + D^2 + D^3 + D^4 + D^6 + D^7$, $g_4(D) = 1 + D^3 + D^5 + D^6$ and $g_5(D) = 1 + D^2 + D^3 + D^4 + D^5 + D^7$ are used to perform the convolutional encoding, to obtain the T=6 component code output bit sequences.

Implementation 14

A value of the constraint length for the convolutional encoding is 10, in this case, the number of shift registers required may be 10-1=9, and the highest power of the preset component code generation polynomial group is 9 and the preset component code generation polynomial group includes at least one of following component code generation polynomials:

$$g_0(D) = 1 + D^1 + D^3 + D^5 + D^6 + D^8 + D^9;$$

$$g_1(D) = 1 + D^2 + D^3 + D^4 + D^5 + D^6 + D^9;$$

$$g_2(D) = 1 + D^2 + D^6 + D^7 + D^8 + D^9;$$

$$g_3(D) = 1 + D^1 + D^2 + D^4 + D^7 + D^8 + D^9;$$

$$g_4(D) = 1 + D^3 + D^5 + D^6 + D^7 + D^9;$$

$$g_5(D) = 1 + D^1 + D^2 + D^3 + D^5 + D^6 + D^9;$$

$$g_6(D) = 1 + D^1 + D^3 + D^5 + D^7 + D^8 + D^9;$$

$$g_7(D) = 1 + D^2 + D^5 + D^6 + D^7 + D^8 + D^9;$$

$$g_8(D) = 1 + D^1 + D^3 + D^4 + D^7 + D^9;$$

$$g_9(D) = 1 + D^1 + D^2 + D^3 + D^4 + D^6 + D^8 + D^9;$$

$$g_{10}(D) = 1 + D^1 + D^3 + D^4 + D^5 + D^6 + D^9;$$

$$g_{11}(D) = 1 + D^3 + D^5 + D^6 + D^7 + D^9.$$

The octal numbers corresponding to the above component code generation polynomials respectively are 1533, 1371, 1217, 1647, 1135, 1731, 1527, 1237, 1545, 1753, 1571 and 1135. When the binary representation is used, the component code generation vectors respectively are: {1, 1, 0, 1, 0, 1, 1, 0, 1, 1}, {1, 0, 1, 1, 1, 1, 1, 0, 0, 1}, {1, 0, 1, 0, 0, 0, 1, 1, 1, 1}, {1, 1, 1, 0, 1, 0, 0, 1, 1, 1}, {1, 0, 0, 1, 0, 1, 1, 1, 0, 1}, {1, 1, 1, 1, 0, 1, 1, 0, 0, 1}, {1, 1, 0, 1, 0, 1, 0, 1, 1, 1}, {1, 0, 1, 0, 0, 1, 1, 1, 1, 1}, {1, 1, 0, 1, 1, 0, 0, 1, 0, 1}, {1, 1, 1, 1, 1, 0, 1, 0, 1, 1}, {1, 1, 0, 1, 1, 1, 1, 0, 0, 1} and {1, 0, 0, 1, 0, 1, 1, 1, 0, 1}.

Furthermore, the sending end may determine the T component code generation polynomials for convolutional encoding from the above component code generation polynomial group. The value of T may be 2, 3, 4, 5, 6, 7, 8, 10 or 12.

In some embodiments, the T component code generation polynomials used in the convolutional encoding include at least the first J component code generation polynomials among the above 12 generation polynomials. Herein, the value of J may be 4, 5, 6, 7, 8, 9, 10 or 12, and J is an integer less than or equal to T.

In an example, the convolutional encoding uses at least 2 of the above 12 generation polynomials for encoding, to obtain the T=2 component code output bit sequences, for example, at least the above generation polynomials $g_0(D) = 1 + D^1 + D^3 + D^5 + D^6 + D^8 + D^9$ and $g_1(D) = 1 + D^2 + D^3 + D^4 + D^5 + D^6 + D^9$ are used to perform the convolutional encoding, to obtain the T=2 component code output bit sequences.

In another example, the convolutional encoding uses at least 3 of the above 12 generation polynomials for encoding, to obtain T=3 component code output bit sequences, for example, at least the above generation polynomials $g_0(D) = 1 + D^1 + D^3 + D^5 + D^6 + D^8 + D^9$, $g_1(D) = 1 + D^2 + D^3 + D^4 + D^5 + D^6 + D^9$ and $g_2(D) = 1 + D^2 + D^6 + D^7 + D^8 + D^9$ are used to perform the convolutional encoding, to obtain the T=3 component code output bit sequences.

In yet another example, the convolutional encoding uses at least 4 of the above 12 generation polynomials for encoding, to obtain T=4 component code output bit sequences, for example, at least the above generation polynomials $g_0(D) = 1 + D^1 + D^3 + D^5 + D^6 + D^5 + D^9$, $g_1(D) = 1 + D^2 + D^3 + D^4 + D^5 + D^6 + D^9$, $g_2(D) = 1 + D^2 + D^6 + D^7 + D^8 + D^9$ and $g_3(D) = 1 + D^1 + D^2 + D^4 + D^7 + D^8 + D^9$ are used to perform the convolutional encoding, to obtain the T=4 component code output bit sequences.

In yet another example, the convolutional encoding uses at least 5 of the above 12 generation polynomials for encoding, to obtain T=5 component code output bit sequences, for example, at least the above generation polynomials $g_0(D) = 1 + D^1 + D^3 + D^5 + D^6 + D^8 + D^9$, $g_1(D) = 1 + D^2 + D^3 + D^4 + D^5 + D^6 + D^9$, $g_2(D) = 1 + D^2 + D^6 + D^7 + D^8 + D^9$, $g_3(D) = 1 + D^1 + D^2 + D^4 + D^7 + D^8 + D^9$ and $g_4(D) = 1 + D^3 + D^5 + D^6 + D^7 + D^9$ are used to perform the convolutional encoding, to obtain the T=5 component code output bit sequences.

In yet another example, the convolutional encoding uses at least 6 of the above 12 generation polynomials for encoding, to obtain T=6 component code output bit sequences, for example, at least the above generation polynomials $g_0(D) = 1 + D^1 + D^3 + D^5 + D^6 + D^8 + D^9$, $g_1(D) = 1 + D^2 + D^3 + D^4 + D^5 + D^6 + D^9$, $g_2(D) = 1 + D^2 + D^6 + D^7 + D^8 + D^9$, $g_3(D) = 1 + D^1 + D^2 + D^4 + D^7 + D^8 + D^9$, $g_4(D) = 1 + D^3 + D^5 + D^6 + D^7 + D^9$ and $g_5(D) = 1 + D^1 + D^2 + D^3 + D^5 + D^6 + D^9$ are used to perform the convolutional encoding, to obtain the T=6 component code output bit sequences.

In yet another example, the convolutional encoding uses at least 8 of the above 12 generation polynomials for encoding, to obtain T= 8 component code output bit sequences, for example, at least the above generation polynomials $g_0(D) = 1 + D^1 + D^3 + D^5 + D^6 + D^8 + D^9$, $g_1(D) = 1 + D^2 + D^3 + D^4 + D^5 + D^6 + D^9$, $g_2(D) = 1 + D^2 + D^6 + D^7 + D^8 + D^9$, $g_3(D) = 1 + D^1 + D^2 + D^4 + D^7 + D^8 + D^9$, $g_4(D) = 1 + D^3 + D^5 + D^6 + D^7 + D^9$, $g_5(D) = 1 + D^1 + D^2 + D^3 + D^5 + D^6 + D^9$, $g_6(D) = 1 + D^1 + D^3 + D^5 + D^7 + D^8 + D^9$ and $g_7(D) = 1 + D^2 + D^5 + D^6 + D^7 + D^8 + D^9$ are used to perform the convolutional encoding, to obtain the T= 8 component code output bit sequences.

In addition the information bit sequence is $b_0$, $b_1$, $b_2$, $b_3$, ..., $b_{K-1}$, K is the length of the information bit sequence, and the specific process of performing the convolutional encoding based on the component code generation polynomials determined in the above examples may refer to the specific description of the convolutional encoding process in the above implementation 1, which will not be repeated herein.

In some embodiments, the preset component code generation polynomial group may further include at least one of the following component code generation polynomials:

$$g_0(D) = 1 + D^1 + D^3 + D^4 + D^6 + D^8 + D^9;$$

$$g_1(D) = 1 + D^3 + D^4 + D^5 + D^6 + D^7 + D^9;$$

$$g_2(D) = 1 + D^1 + D^2 + D^3 + D^7 + D^9;$$

$$g_3(D) = 1 + D^1 + D^2 + D^5 + D^7 + D^8 + D^9;$$

$$g_4(D) = 1 + D^2 + D^3 + D^4 + D^6 + D^9;$$

$$g_5(D) = 1 + D^3 + D^4 + D^6 + D^7 + D^8 + D^9;$$

$$g_6(D) = 1 + D^1 + D^2 + D^4 + D^6 + D^8 + D^9;$$

$$g_7(D) = 1 + D^1 + D^2 + D^3 + D^4 + D^7 + D^9;$$

$$g_8(D) = 1 + D^2 + D^5 + D^6 + D^8 + D^9;$$

$$g_9(D) = 1 + D^1 + D^3 + D^5 + D^6 + D^7 + D^8 + D^9;$$

$$g_{10}(D) = 1 + D^1 + D^2 + D^3 + D^5 + D^6 + D^9;$$

$$g_{11}(D) = 1 + D^2 + D^3 + D^4 + D^6 + D^9.$$

The octal numbers corresponding to the above respective component code generation polynomials respectively correspond to 1553, 1175, 1705, 1627, 1351, 1157, 1653, 1745, 1233, 1537, 1731 and 1351. When the binary representation is used, the respective component code generation vectors correspond to {1, 1, 0, 1, 1, 0, 1, 0, 1, 1}, {1, 0, 0, 1, 1, 1, 1, 1, 0, 1}, {1, 1, 1, 1, 0, 0, 0, 1, 0, 1}, {1, 1, 1, 0, 0, 1, 0, 1, 1, 1}, {1, 0, 1, 1, 1, 0, 1, 0, 0, 1}, {1, 0, 0, 1, 1, 0, 1, 1, 1, 1}, {1, 1, 1, 0, 1, 0, 1, 0, 1, 1}, {1, 1, 1, 1, 1, 0, 0, 1, 0, 1}, {1, 0, 1, 0, 0, 1, 1, 0, 1, 1}, {1, 1, 0, 1, 0, 1, 1, 1, 1, 1}, {1, 1, 1, 1, 0, 1, 1, 0, 0, 1} and {1, 0, 1, 1, 1, 0, 1, 0, 0, 1}.

Furthermore, the sending end may determine the T component code generation polynomials for convolutional encoding from the above component code generation polynomial group. The value of T may be 2, 3, 4, 5, 6, 7, 8, 10, or 12. In some embodiments, the T component code generation polynomials used in the convolutional encoding include at least the first J component code generation polynomials among the above 12 generation polynomials. Herein, the value of J may be 4, 5, 6, 7, 8, 9, 10 or 12, and J is an integer less than or equal to T.

Implementation 15

A value of the constraint length for the convolutional encoding is 11, in this case, the number of shift registers required may be 11-1= 10, and the highest power of the preset component code generation polynomial group is 10 and the preset component code generation polynomial group includes at least one of following component code generation polynomials:

$$g_0(D) = 1 + D^3 + D^5 + D^6 + D^7 + D^{10};$$

$$g_1(D) = 1 + D^1 + D^3 + D^4 + D^5 + D^6 + D^{10};$$

$$g_2(D) = 1 + D^1 + D^2 + D^4 + D^5 + D^6 + D^8 + D^{10};$$

$$g_3(D) = 1 + D^1 + D^4 + D^5 + D^6 + D^7 + D^9 + D^{10};$$

$$g_4(D) = 1 + D^2 + D^4 + D^7 + D^8 + D^9 + D^{10};$$

$$g_5(D) = 1 + D^2 + D^3 + D^4 + D^5 + D^7 + D^8 + D^{10};$$

$$g_6(D) = 1 + D^3 + D^4 + D^5 + D^7 + D^9 + D^{10};$$

$$g_7(D) = 1 + D^1 + D^3 + D^4 + D^5 + D^6 + D^7 + D^{10};$$

$$g_8(D) = 1 + D^2 + D^5 + D^6 + D^8 + D^9 + D^{10};$$

$$g_9(D) = 1 + D^2 + D^4 + D^7 + D^8 + D^9 + D^{10};$$

$$g_{10}(D) = 1 + D^1 + D^2 + D^3 + D^4 + D^6 + D^7 + D^{10};$$

$$g_{11}(D) = 1 + D^1 + D^2 + D^3 + D^5 + D^7 + D^9 + D^{10}.$$

The octal numbers corresponding to the above component code generation polynomials respectively are 2271, 3361, 3565, 3173, 2517, 2755, 2353, 3371, 2467, 2517, 3731 and 3653. When the binary representation is used, the component code generation vectors respectively are: {1, 0, 0, 1, 0, 1, 1, 1, 0, 0, 1}, {1, 1, 0, 1, 1, 1, 1, 0, 0, 0, 1}, {1, 1, 1, 0, 1, 1, 1, 0, 1, 0, 1}, {1, 1, 0, 0, 1, 1, 1, 1, 0, 1, 1}, {1, 0, 1, 0, 1, 0, 0, 1, 1, 1, 1}, {1, 0, 1, 1, 1, 1, 0, 1, 1, 0, 1}, {1, 0, 0, 1, 1, 1, 0, 1, 0, 1, 1}, {1, 0, 1, 1, 1, 1, 1, 0, 0, 1}, {1, 0, 1, 0, 0, 1, 1, 0, 1, 1, 1}, {1, 0, 1, 0, 1, 0, 0, 1, 1, 1, 1}, {1, 1, 1, 1, 1, 0, 1, 1, 0, 0, 1} and {1, 1, 1, 1, 0, 1, 0, 1, 0, 1, 1}.

Furthermore, the sending end may determine the T component code generation polynomials for convolutional encoding from the above component code generation polynomial group. The value of T may be 2, 3, 4, 5, 6, 7, 8, 10 or 12.

In some embodiments, the T component code generation polynomials used in the convolutional encoding include at least the first J component code generation polynomials among the above 12 generation polynomials. Herein, the value of J may be 4, 5, 6, 7, 8, 9, 10 or 12, and J is an integer less than or equal to T.

In an example, the convolutional encoding uses at least 2 of the above 12 generation polynomials for encoding, to obtain the T=2 component code output bit sequences, for example, at least the above generation polynomials $g_0(D) = 1 + D^3 + D^5 + D^6 + D^7 + D^{10}$ and $g_1(D) = 1 + D^1 + D^3 + D^4 + D^5 + D^6 + D^{10}$ are used to perform the convolutional encoding, to obtain the T=2 component code output bit sequences.

In another example, the convolutional encoding uses at least 3 of the above 12 generation polynomials for encoding, to obtain T=3 component code output bit sequences, for example, at least the above generation polynomials $g_0(D) = 1 + D^3 + D^5 + D^6 + D^7 + D^{10}$, $g_1(D) = 1 + D^1 + D^3 + D^4 + D^5 + D^6 + D^{10}$ and $g_2(D) = 1 + D^1 + D^2 + D^4 + D^5 + D^6 + D^8 + D^{10}$ are used to perform the convolutional encoding, to obtain the T=3 component code output bit sequences.

In yet another example, the convolutional encoding uses at least 4 of the above 12 generation polynomials for encoding, to obtain T=4 component code output bit sequences, for example, at least the above generation polynomials $g_0(D) = 1 + D^3 + D^5 + D^6 + D^7 + D^{10}$, $g_1(D) = 1 + D^1 + D^3 + D^4 + D^5 + D^6 + D^{10}$, $g_2(D) = 1 + D^1 + D^2 + D^4 + D^5 + D^6 + D^8 + D^{10}$ and $g_3(D) = 1 + D^1 + D^4 + D^5 + D^6 + D^7 + D^9 + D^{10}$ are used to perform the convolutional encoding, to obtain the T=4 component code output bit sequences.

In yet another example, the convolutional encoding uses at least 5 of the above 12 generation polynomials for encoding, to obtain T=5 component code output bit sequences, for example, at least the above generation polynomials $g_0(D) = g_0(D) = 1 + D^3 + D^5 + D^6 + D^7 + D^{10}$, $g_1(D) = 1 + D^1 + D^3 + D^4 + D^5 + D^6 + D^{10}$, $g_2(D) = 1 + D^1 + D^2 + D^4 + D^5 + D^6 + D^8 + D^{10}$, $g_3(D) = 1 + D^1 + D^4 + D^5 + D^6 + D^7 + D^9 + D^{10}$ and $g_4(D) = 1 + D^2 + D^4 + D^7 + D^8 + D^9 + D^{10}$ are used to perform the convolutional encoding, to obtain the T=5 component code output bit sequences.

In yet another example, the convolutional encoding uses at least 6 of the above 12 generation polynomials for encoding, to obtain T=6 component code output bit sequences, for example, at least the above generation polynomials $g_0$ (D) = $1 + D^3 + D^5 + D^6 + D^7 + D^{10}$, $g_1$(D) = $1 + D^1 + D^3 + D^4 + D^5 + D^6 + D^{10}$, $g_2$(D) = $1 + D^1 + D^2 + D^4 + D^5 + D^6 + D^8 + D^{10}$, $g_3$ (D) = $1 + D^1 + D^4 + D^5 + D^6 + D^7 + D^9 + D^{10}$, $g_4$(D) = $1 + D^2 + D^4 + D^7 + D^8 + D^9 + D^{10}$, $g_5$(D) = $1 + D^2 + D^3 + D^4 + D^5 + D^7 + D^8 + D^{10}$ are used to perform the convolutional encoding, to obtain the T=6 component code output bit sequences.

In yet another example, the convolutional encoding uses at least 8 of the above 12 generation polynomials for encoding, to obtain T=8 component code output bit sequences, for example, at least the above generation polynomials $g_0$ (D) = $1 + D^3 + D^5 + D^6 + D^7 + D^{10}$, $g_1$(D) = $1 + D^1 + D^3 + D^4 + D^5 + D^6 + D^{10}$, $g_2$(D) = $1 + D^1 + D^2 + D^4 + D^5 + D^6 + D^8 + D^{10}$, $g_3$ (D) = $1 + D^1 + D^4 + D^5 + D^6 + D^7 + D^9 + D^{10}$, $g_4$(D) = $1 + D^2 + D^4 + D^7 + D^8 + D^9 + D^{10}$, $g_5$(D) = $1 + D^2 + D^3 + D^4 + D^5 + D^7 + D^8 + D^{10}$, $g_6$(D) = $1 + D^3 + D^4 + D^5 + D^7 + D^9 + D^{10}$ and $g_7$(D) = $1 + D^1 + D^3 + D^4 + D^5 + D^6 + D^7 + D^{10}$ are used to perform the convolutional encoding, to obtain the T=8 component code output bit sequences.

In addition, the information bit sequence is $b_0$, $b_1$, $b_2$, $b_3$, ..., $b_{K-1}$, K is the length of the information bit sequence, and the specific process of performing the convolutional encoding based on the component code generation polynomials determined in the above examples may refer to the specific description of the convolutional encoding process in the above implementation 1, which will not be repeated herein.

In some embodiments, the preset component code generation polynomial group may further include at least one of the following component code generation polynomials:

$$g_0(D) = 1 + D^3 + D^4 + D^5 + D^7 + D^{10};$$

$$g_1(D) = 1 + D^4 + D^5 + D^6 + D^7 + D^9 + D^{10};$$

$$g_2(D) = 1 + D^2 + D^4 + D^5 + D^6 + D^8 + D^9 + D^{10};$$

$$g_3(D) = 1 + D^1 + D^3 + D^4 + D^5 + D^6 + D^9 + D^{10};$$

$$g_4(D) = 1 + D^1 + D^2 + D^3 + D^6 + D^8 + D^{10};$$

$$g_5(D) = 1 + D^2 + D^3 + D^5 + D^6 + D^7 + D^8 + D^{10};$$

$$g_6(D) = 1 + D^1 + D^3 + D^5 + D^6 + D^7 + D^{10};$$

$$g_7(D) = 1 + D^3 + D^4 + D^5 + D^6 + D^7 + D^9 + D^{10};$$

$$g_8(D) = 1 + D^1 + D^2 + D^4 + D^5 + D^8 + D^{10};$$

$$g_9(D) = 1 + D^1 + D^2 + D^3 + D^6 + D^8 + D^{10};$$

$$g_{10}(D) = 1 + D^3 + D^4 + D^6 + D^7 + D^8 + D^9 + D^{10};$$

$$g_{11}(D) = 1 + D^1 + D^3 + D^5 + D^7 + D^8 + D^9 + D^{10}.$$

The octal numbers corresponding to the above respective component code generation polynomials respectively correspond to 2351, 2173, 2567, 3363, 3625, 2675, 3271, 2373, 3545, 3625, 2337 and 3257. When the binary representation is used, the respective component code generation vectors correspond to {1, 0, 0, 1, 1, 1, 0, 1, 0, 0, 1}, {1, 0, 0, 0, 1, 1, 1, 1, 0, 1, 1}, {1, 0, 1, 0, 1, 1, 1, 0, 1, 1, 1}, {1, 1, 0, 1, 1, 1, 1, 0, 0, 1, 1}, {1, 1, 1, 1, 0, 0, 1, 0, 1, 0, 1}, {1, 0, 1, 1, 0, 1, 1, 1, 1, 0, 1}, {1, 1, 0, 1, 0, 1, 1, 1, 0, 0, 1}, {1, 0, 0, 1, 1, 1, 1, 1, 0, 1, 1}, {1, 1, 1, 0, 1, 1, 0, 0, 1, 0, 1}, {1, 1, 1, 1, 0, 0, 1, 0, 1, 0, 1}, {1, 0, 0, 1, 1, 0, 1, 1, 1, 1, 1} and {1, 1, 0, 1, 0, 1, 0, 1, 1, 1, 1}.

Furthermore, the sending end may determine the T component code generation polynomials for convolutional encoding from the above component code generation polynomial group. The value of T may be 2, 3, 4, 5, 6, 7, 8, 10 or 12. In some embodiments, the T component code generation polynomials used in the convolutional encoding include at least the first J component code generation polynomials among the above 12 generation polynomials. Herein, the value of J may be 4, 5, 6, 7, 8, 9, 10 or 12, and J is an integer less than or equal to T.

It should be noted that, the present disclosure provides a plurality of possible implementations for preset component code generation polynomials with different constraint lengths for convolutional encoding and support for flexible code rate design. Furthermore, the number of non-zero coefficients in the provided component code generation polynomials is small. By performing the convolutional encoding using the component code generation polynomials provided in the embodiments of the present disclosure, the weight of the component codes is reduced, and the number of XOR gates is also reduced, which may reduce the complexity of convolutional encoding and improve the robustness of data communication.

In S103, sub-block interleaving is performed on an i-th component code output bit sequence, to obtain a sub-block interleaved output sequence.

Herein, i is a non-negative integer less than T.

In some embodiments, the value of i is determined according to one or more of: a number of component codes T, encoding rate, a number of sent bits, a number of resource elements, a length of an output bit sequence of a single component code among the T component codes, a modulation order, a number of multi-antenna layers, a constraint length for convolutional encoding, and a length of the information bit sequence. Manners for determining the value of i are explained below through specific examples:

Example 1, the value of i is determined according to T and the encoding rate.

In some embodiments, the value of i is determined based on the following Formula (1).

$$i = \mod(\mathrm{floor}(1/R), T) \qquad \text{Formula (1)}$$

Herein, R is the encoding rate, function floor(x) is a floor function, for example, floor (3. 3)=3, mod (7, 4) =3, function mod (a, b) is a modulo operation and represents a remainder obtained by dividing a by b, R is a real number greater than 0, and a and b are positive integers. Also, "/" represents a real number division operation.

Exemplarily, if the constraint length for the convolutional encoding is 7 and T is 4, the T component code generation polynomials are:

$$g_0(D) = 1 + D^2 + D^3 + D^5 + D^6;$$

$$g_1(D) = 1 + D^1 + D^2 + D^3 + D^6;$$

$$g_2(D) = 1 + D^1 + D^2 + D^4 + D^6;$$

$$g_3(D) = 1 + D^2 + D^5 + D^6.$$

The corresponding octal numbers respectively are 133, 171, 165 and 123. When the binary representation is used, 4 component code generation vectors respectively are: {1,0,1,1,0,1,1}, {1,1,1,1,0,0,1}, {1,1,1,0,1,0,1} and {1,0,1,0,0,1,1}.

Taking an example in which the information bit sequence is $b_0, b_1, b_2, b_3, ..., b_{K-1}$ and K=80, the sending end, after performing convolutional encoding on the information bit sequence, may obtain four component code output bit sequences with a length of 80 bits. If the encoding rate is R = 2/5, then based on the above Formula (1), i = mod (floor (1/R), T) = 2. That is, the sending end needs to perform sub-block interleaving on the output bit sequence of the second component code, to obtain a sub-block interleaved output sequence.

In some embodiments, the sending end may further combine the 0-th component code, 1st component code, and 3rd component code and the sub-block interleaved output sequence of the 2nd component code into a total bit sequence, that is, an encoded bit sequence. Herein, the corresponding component code order in the encoded bit sequence is 0, 1, 2, and 3, where 0, 1, and 3 are the component code output bit sequences, and 2 is the sub-block interleaved output sequence.

Example 2, the value of i is determined according to T, the length of the information bit sequence and the number of sent bits.

In some embodiments, the value of i is determined based on the following Formula (2):

$$i=mod\ (floor(E/K),\ T) \qquad\qquad Formula\ (2)$$

Herein, K is the length of the information bit sequence, E is the number of sent bits, function floor(x) is a floor function, function mod (a, b) is a modulo operation, and represents a remainder obtained by dividing a by b, and K, E, a, and b are all positive integers.

Exemplarily, taking an example of the four component code generation polynomials in the above Example 1, if the constraint length for the convolutional encoding is 7, T is 4, and the information bit sequence is $b_0, b_1, b_2, b_3, ..., b_{K-1}$, and K=64.

Therefore, the sending end, after performing convolutional encoding on the information bit sequence, may obtain four component code output bit sequences with a length of 64 bits. If the number of bits is E=300, then based on the above Formula (2), i=mod (floor (E/K), T) = 0. That is, the sending end needs to perform sub-block interleaving on the output bit sequence of the 0-th component code, to obtain a sub-block interleaved output sequence.

In some embodiments, the sending end may further combine the 1st component code, 2nd component code and 3rd component code and the sub-block interleaved output sequence of the 0-th component code into a total bit sequence, that is, an encoded bit sequence. Herein, the corresponding component code order in the encoded bit sequence is 0, 1, 2, and 3, where 1, 2 and 3 are the component code output bit sequences, and 0 is the sub-block interleaved output sequence.

Example 3, the value of i is determined according to T, the number of sent bits, and the length of the output bit sequence of a single component code among the T component codes.

In some embodiments, the value of i is determined based on the following Formula (3):

$$i=mod\ (floor(E/M),\ T) \qquad\qquad Formula\ (3)$$

Herein, M is the length of the output bit sequence of the single component code among the T component codes, E is the number of sent bits, function floor(x) is a floor function, function mod (a, b) is a modulo operation, and represents a remainder obtained by dividing a by b, and E, M, a, and b are all positive integers.

In some embodiments, the length M of the output bit sequence of the single component code is an integer greater than or equal to the length K of the information bit sequence. Exemplarily, if the sending end uses convolutional encoding with both the first state and last state being 0, the length M of the output bit sequence of the single component code may be equal to a sum of the length K of the information bit sequence and the constraint length L of the convolutional encoding minus 1, that is, M=K+L-1. For example, the convolutional encoding is performed based on the four component code generation polynomials in Example 1, the constraint length L is equal to 7, and there are L-1=6 shift registers. If the sending end uses the convolutional encoding with the first state and last state both being 0, then during the convolutional encoding process, initial values of the six shift registers are all equal to 0 and in order to ensure that the first state and last state of the convolutional encoding are both equal to 0, after all the bits of the information bit sequence are input, L-1=6 zeros need to be input again, so that the initial values of the shift registers $S_0, S_1, S_2, S_3, S_4$ and $S_5$ are all equal to 0 and after all the bits of the information bit sequence are input, 6 more zeros need to be input to ensure that final values of the shift registers $S_0, S_1, S_2, S_3, S_4$ and $S_5$ are also equal to 0. The output corresponding to the a-th component code is $C_k^{(a)}$, where a=0, 1, ..., T-1 and k=0, 1, ..., K+L-2.

Exemplarily, taking an example of four component code generation polynomials in the above Example 1, if the constraint length for the convolutional encoding is 7, T is 4, and the information bit sequence is $b_0, b_1, b_2, b_3, ..., b_{K-1}$, and K=64. Therefore, if the sending end uses convolutional encoding with both the first state and last state being 0, and the sending end, after performing the convolutional encoding on the information bit sequence, may obtain four component code output bit sequences with a length of M = K+L - 1 = 70 bits. If the number of bits is E=256, then based on the above Formula (3), i=mod (floor (E/m), T) =3. That is, the sending end needs to perform sub-block interleaving on the output bit sequence of the 3rd component code, to obtain a sub-block interleaved output sequence.

In some embodiments, the sending end may further combine the 0-th component code, 1st component code, and 2nd component code and the sub-block interleaved output sequence of the 3rd component code into a total bit sequence, that is, an encoded bit sequence. Herein, the corresponding component code order in the encoded bit sequence is 0, 1, 2, and 3, where 0, 1, and 2 are the component code output bit sequences, and 3 is the sub-block interleaved output sequence.

Example 4, the value of i is determined according to T, the length of the output bit sequence of a single component code among the T component codes, the number of resource elements, and the modulation order.

In some embodiments, the value of i is determined based on the following Formula (4):

$$i=mod\ (floor(((S*Q))/M),\ T) \qquad\qquad Formula\ (4)$$

Herein, M is the length of the output bit sequence of the single component code among the T component codes, S is the number of resource elements, Q is the modulation order, function floor(x) is a floor function, function mod (a, b) is a modulo operation, and represents a remainder obtained by dividing a by b, and S, Q, M, a, and b are all positive integers. And, "*" represents a real number multiplication operation. As a possible example, the number of resource elements S is equal to the number of modulation symbols. The modulation order is an integer greater than 0, which describes the number of bits mapped to a modulation symbol. In a specific example, if the modulation order Q is equal to 1, it corresponds to BPSK modulation; if the modulation order Q is equal to 2, it corresponds to QPSK modulation; if the modulation order Q is equal to 4, it corresponds to 16QAM modulation; if the modulation order Q is equal to 6, it corresponds to 64QAM modulation; if the modulation order Q is equal to 8, it corresponds to 256QAM modulation; if the modulation order Q is equal to 10, it corresponds to 1024QAM modulation.

In an example, if taking an example of four component code generation polynomials in the above Example 1, if the constraint length for the convolutional encoding is 7, T is 4, and the information bit sequence is $b_0, b_1, b_2, b_3, ..., b_{K-1}$, and K=64. Therefore, if the sending end uses convolutional encoding with both the first state and last state being 0, and the sending end, after performing the convolutional encoding on the information bit sequence, may obtain four component code output bit sequences with a length of M = K+L - 1 = 70 bits. If the number of resource elements is S=100 and the modulation order is Q=2, then based on the above Formula (4), i=mod (floor (((S*Q))/M), T) =2. That is, the sending end needs to perform sub-block interleaving on the output bit sequence of the second component code, to obtain a sub-block interleaved output sequence. In some embodiments, the sending end may further combine the 0-th component code, 1st component code, and 3rd component code and the sub-block interleaved output sequence of the 2nd component code into a total bit sequence, that is, an encoded bit sequence. Herein, the corresponding component code order in the output bit sequence is 0, 1, 2, and 3, where 0, 1, and 3 are the component code output bit sequences, and 2 is the sub-block interleaved output sequence.

Example 5, the value of i is determined according to T, the length of the output bit sequence of a single component code among the T component codes, the number of resource elements, the modulation order and the number of multi-antenna layers.

In some embodiments, the value of i is determined based on the following Formula (5):

$$i=\text{mod (floor } (((S*Q*V))/M), T) \qquad\qquad \text{Formula (5)}$$

Herein, M is the length of the output bit sequence of the single component code among the T component codes, S is the number of resource elements, Q is the modulation order, V is the number of multi-antenna layers, function floor(x) is a floor function, function mod (a, b) is a modulo operation, and represents a remainder obtained by dividing a by b, and S, Q, M, V, a, and b are all positive integers. Herein, the number of multi-antenna layers V is an integer greater than 0. Specifically, the number of multi-antenna layers V may be equal to 1, 2, 3, 4, 6, or 8.

Exemplarily, taking an example of six component code generation polynomials in the above implementation 6, if the constraint length for the convolutional encoding is 9, T is 6, and the information bit sequence is $b_0, b_1, b_2, b_3, ..., b_{K-1}$, and K=64. Therefore, if the sending end uses the tail-biting convolutional code manner to perform the convolutional encoding on the information bit sequence, four component code output bit sequences with a length of M =64 bits may be obtained. When the tail-biting convolutional encoding is performed, the length M of the output bit sequence of a single component code is equal to the length K of the information bit sequence. If the number of resource elements is S = 220, the modulation order is Q = 1, and the number of multi-antenna layers is V = 4, then based on the above Formula (5), i=mod (floor ((S*Q*V)/M), T) =1. That is, the sending end needs to perform sub-block interleaving on the output bit sequence of the 1st component code, to obtain a sub-block interleaved output sequence.

In some embodiments, the sending end may further combine output bit sequences of the 0-th component code, 2nd component code, 3rd component code, 4th component code and 5th component code and the sub-block interleaved output sequence of the 1st component code into a total bit sequence, that is, an encoded bit sequence. Herein, the corresponding component code order in the encoded bit sequence is 0, 1, 2, 3, 4 and 5, where 0, 2, 3, 4 and 5 are the component code output bit sequences, and 1 is the sub-block interleaved output sequence.

Example 6, the value of i is determined according to the length of the output bit sequence of a single component code among the T component codes, and the number of sent bits.

In some embodiments, the value of i is determined based on the following Formula (6):

$$i=\text{floor } (E/M) \qquad\qquad \text{Formula (6)}$$

Herein, M is the length of the output bit sequence of the single component code among the T component codes, E is the number of sent bits, and function floor(x) is a floor function.

Furthermore, after i is determined, the sub-block interleaving may be performed on the output bit sequence of the i-th component code, to obtain the sub-block interleaved output sequence.

In some embodiments, the sub-block interleaving may be implemented based on an interleaving matrix and an inter-column permutation index set, and elements in the inter-column permutation index set are all non-negative integers.

In some embodiments, a number of columns of the interleaving matrix is determined based on a length of the inter-column permutation index set, and a number of rows of the interleaving matrix is determined based on a length of the i-th component code output bit sequence. Furthermore, the number of rows of the interleaving matrix is determined based on the following Formula (7):

$$(R \cdot C) \geqslant M \qquad\qquad \text{Formula (7)}$$

Herein, R is the number of rows of the interleaving matrix, C is the number of columns of the interleaving matrix, and M is the length of the i-th component code output bit sequence.

Exemplarily, if the i-th component code output bit sequence for sub-block interleaving is $d_0^i$, $d_1^i$, $d_2^i$, ..., $d_{M-1}^i$, the length is M. If the interleaving matrix satisfies $(R \cdot C) \geqslant M$, then a number of NULL bits with $L_F = (R \cdot C) - M$ need to be padded. After padding the NULL bits, the sequence y may be acquired, where the head of y is the padded NULL bits and the tail is the output sequence of the ith component code, that is, represented as $y_k = <\text{NULL}>$ for

k = 0, 1,..., $L_F$-1, and $y_{L_F+k} = d_k^i$, where k = 0, 1,..., M-1. The sequence y is written into the interleaving matrix of the sub-block interleaving according to an order of rows.

In some embodiments, a length of the inter-column permutation index set is 8, 16, 32, or 64. In an example, a length of the inter-column permutation index set is 8, and the inter-column permutation index set P = [0, 4, 2, 6, 1, 5, 3, 7] or [1, 5, 3, 7, 0, 4, 2, 6]. In another example, the length of the inter-column permutation index set is 16, and the inter-column permutation index set P = [0, 8, 4, 12, 2, 10, 6, 14, 1, 9, 5, 13, 3, 11, 7, 15] or [1, 9, 5, 13, 3, 11, 7, 15, 0, 8, 4, 12, 2, 10, 6, 14]. In yet another example, the length of the inter-column permutation index set is 32, and the inter-column permutation index set is [0, 16, 8, 24, 4, 20, 12, 28, 2, 18, 10, 26, 6, 22, 14, 30, 1, 17, 9, 25, 5, 21, 13, 29, 3, 19, 11, 27, 7, 23, 15, 31]. In yet another example, the length of the inter-column permutation index set is 64, and the inter-column permutation index set is [0, 32, 16, 48, 8, 40, 24, 56, 4, 36, 20, 52, 12, 44, 28, 60, 2, 34, 18, 50, 10, 42, 26, 58, 6, 38, 22, 54, 14, 46, 30, 62, 1, 33, 17, 49, 9, 41, 25, 57, 5, 37, 21, 53, 13, 45, 29, 61, 3, 35, 19, 51, 11, 43, 27, 59, 7, 39, 23, 55, 15, 47, 31, 63] or [1, 33, 17, 49, 9, 41, 25, 57, 5, 37, 21, 53, 13, 45, 29, 61, 3, 35, 19, 51, 11, 43, 27, 59, 7, 39, 23, 55, 15, 47, 31, 63, 0, 32, 16, 48, 8, 40, 24, 56, 4, 36, 20, 52, 12, 44, 28, 60, 2, 34, 18, 50, 10, 42, 26, 58, 6, 38, 22, 54, 14, 46, 30, 62].

Furthermore, the sending end performs column permutation on the interleaving matrix of the sub-block interleaving based on the inter-column permutation index set P, and the j-th column of the interleaving matrix after permutation is equal to the P(j)-th column in the original interleaving matrix, where j is equal to 0, 1, 2, ..., C-1. Read the size of R×C matrix sequentially column by columns starting from column 0 after column permutation. Skip any NULL bits encountered during the reading process to obtain the sub-block interleaved output sequence corresponding to the i-th component code, with its length equal to M.

In some embodiments, the sending end may also read the P(j)-th bit from the interleaving matrix sequentially based on the value of j in the order of 0, 1, 2, ..., and remove the read NULL bits to form the sub-block interleaved output sequence of the i-th component code.

Example 7, the value of i is determined according to T, the length of the output bit sequence of the single component code, the starting position index, and the number of sent bits.

In some embodiments, the value of i is determined based on the following Formula (8):

$$i = \text{mod} (\text{floor}((E+x)/M), T) \qquad\qquad \text{Formula (8)}$$

Herein, M is the length of the output bit sequence of the single component code, x is the starting position index, E is the number of sent bits, function floor(x) is the floor function, function mod (a, b) is the modulo operation, and represents a remainder obtained by dividing a by b, and K, E, x, a, and b are all positive integers.

Exemplarily, taking an example of four component code generation polynomials in the above Example 1, if the constraint length for the convolutional encoding is 7, T is 4, and the information bit sequence is $b_0$, $b_1$, $b_2$, $b_3$, ..., $b_{K-1}$, and K=64.

Therefore, the sending end, after performing convolutional encoding on the information bit sequence, may obtain four component code output bit sequences with a length of 64 bits. If the number of bits is E=300 and the starting position index x is 10, then based on the above Formula (2), i = mod (floor((E+x)/M), T) = 0. That is, the sending end needs to perform sub-block interleaving on the output bit sequence of the 0-th component code, to obtain a sub-block interleaved output sequence.

In some embodiments, the sending end may further combine output bit sequences of the 1st component code, 2nd component code and 3rd component code and the sub-block interleaved output sequence of the 0-th component code into a total bit sequence, that is, an encoded bit sequence. Herein, the component code order corresponding to the encoded bit sequence is 0, 1, 2, and 3, where 1, 2 and 3 are the component code output bit sequences, and 0 is the sub-block interleaved output sequence.

Example 8, the value of i may be equal to null (which may also be represented by null or a negative number (such as -1)), and may be equal to a non-negative integer. If the value of i is null, there is no need to perform sub-block interleaving on the component code output bit sequence.

In some embodiments, the value of i is determined according to the number of component codes T, the length K of the information bit sequence, and the number E of sent bits. Herein, if E is a positive integer multiple of K, the value of i is equal to null; otherwise, the value of i is determined based on Formula (2). In a specific example, if E is equal to 128, K is equal to 64, and T is equal to 3, the value of i is null.

In some embodiments, the value of i is determined according to the number of component codes T, the length M of the output bit sequence of the single component code, and the number E of sent bits. Herein, if E is a positive integer multiple of M, the value of i is equal to null; otherwise, the value of i is determined based on Formula (3). In a specific example, if E is equal to 256, M is equal to 64, and T is equal to 6, the value of i is null.

In some embodiments, the value of i is determined according to the number of component codes T, the length M of the output bit sequence of the single component code, the number of resource elements S, and the modulation order Q. Herein, if S * Q is equal to a positive integer multiple of M, the value of i is equal to null; otherwise, the value of i is determined based on Formula (4). In a specific example, the number of resource elements S is equal to 256, the modulation order Q is equal to 2, M is equal to 128, and T is equal to 6, the value of i is null.

In some embodiments, the value of i is determined according to the number of component codes T, the length M of the output bit sequence of the single component code, the number of resource elements S, the modulation order Q, and the number of multi-antenna layers V. Herein, if S * Q * V is equal to a positive integer multiple of M, the value of i is equal to null; otherwise, the value of i is determined based on Formula (5). In a specific example, the number of resource elements S is equal to 256, the modulation order Q is equal to 2, the number of multi-antenna layers V is equal to 3, M is equal to 128, and T is equal to 8, then the value of i is null.

In some embodiments, the value of i is determined according to the length M of the output bit sequence of the single component code and the number E of sent bits. Herein, if E is a positive integer multiple of M, the value of i is equal to null; otherwise, the value of i is determined based on Formula (6). In a specific example, if E is equal to 200, M is equal to 50, and T is equal to 4, the value of i is null.

In some embodiments, the value of i is determined according to the number of component codes T, the length M of the output bit sequence of the single component code, the starting position index x, and the number E of sent bits. Herein, if E+x is a positive integer multiple of M, the value of i is equal to null; otherwise, the value of i is determined based on Formula (8). In a specific example, if E is equal to 220, x is equal to 20, M is equal to 80, and T is equal to 4, the value of i is null.

In S104, an encoded bit sequence according to the sub-block interleaved output sequence and other component code bit sequences among the T component code bit sequences and except the i-th component code bit sequence is determined.

Exemplarily, the sending end may combine the output bit sequences of 0-th component code, 1-th component code, ..., (i-1)-th component code, (i+1)-th component code, ... (T-1)-th component code and the sub-block interleaved output sequence of the i-th component code into a total bit sequence (i.e., an encoded bit sequence), the length of the encoded bit sequence is equal to T*M. Furthermore, a part or all of the bits in the encoded bit sequence may be selected as to-be-sent bits. The (t*M)-th bit to the ((t+1)*M-1)-th bit in the encoded bit sequence is composed of the output bit sequence of the t-th component code, where t is a non-negative integer less than T and t is not equal to i. If t is equal to i, the (t*M)-th bit to the ((t+1)*M-1) *-th bit in the total bit sequence is composed of the sub-block interleaved output sequence of the i-th component code.

As shown in FIG. 4, if the encoded bit sequence 400 includes T bit sequences of length M, where the first i-1 bit sequences are the output bit sequences of 0-th component code to (i-1)-th component code, the i-th bit sequence 402 is the sub-block interleaved output sequence, and the other bit sequences are the output bit sequences of (i+1)-th component code to (T-1)-th component code.

In an example, if i=0, it represents that the 0-th bit sequence in the encoded bit sequence 400 is a sub-block interleaved output sequence, and the 1st bit sequence to the (T-1)-th bit sequence in the encoded bit sequence 400 respectively correspond to the output bit sequences of the 1st component code to the output bit sequences of the (T-1)-th component code.

In another example, if i=T-1, it represents that the (T-1)-th bit sequence in the encoded bit sequence 400 is a sub-block interleaved output sequence, and the 0-th bit sequence to the (T-2)-th bit sequence in the encoded bit sequence 400 respectively correspond to the output bit sequences of the 0-th component code to the output bit sequences of the (T-2)-th component code.

It should be noted that, in this step, sub-block interleaving is not required for the other component code output bit sequences. Thus, the interleaving process of convolutional encoding may be reduced and the complexity of encoding may be reduced.

In some embodiments, the sending end may further send all or a part of the bits in the encoded bit sequence based on the determined encoded bit sequence.

Exemplarily, the sending end may perform bit selection on the encoded bit sequence, to obtain the to-be-sent bit sequence, where cyclic selection is performed starting from the 0-th bit in the total bit sequence and if the last bit is selected, the selection continues from the first bit, and stops when the required number of bits is obtained.

Exemplarily, the sending end may perform bit selection on the encoded bit sequence, to obtain the to-be-sent bit sequence, where cyclic selection is performed starting from the x-th bit in the total bit sequence and if the last bit is selected, the selection continues from the first bit, and stops when the required number of bits is obtained. Herein, x is the starting position index, and x is an integer greater than or equal to 0.

In a possible implementation, the sending end may combine the output bit sequences of the 0-th component code, 1st component code, ..., (i-1) component code, (i+1) component code, ..., (T-1)-th component code and the sub-block interleaved output sequence of the i-th component code into an encoded bit sequence, perform bit selection on the encoded bit sequence, to obtain a to-be-sent bit sequence, and send the to-be-sent bit sequence.

In another possible implementation, the sending end may perform bit selection on the sub-block interleaved output sequence, to obtain the bit sequence after bit selection. Furthermore, the sending end may send the output bit sequences of the 0-th component code, 1st component code, ..., (i-1) component code, (i+1) component code, ..., (T-1)-th component code and the bit sequence after bit selection.

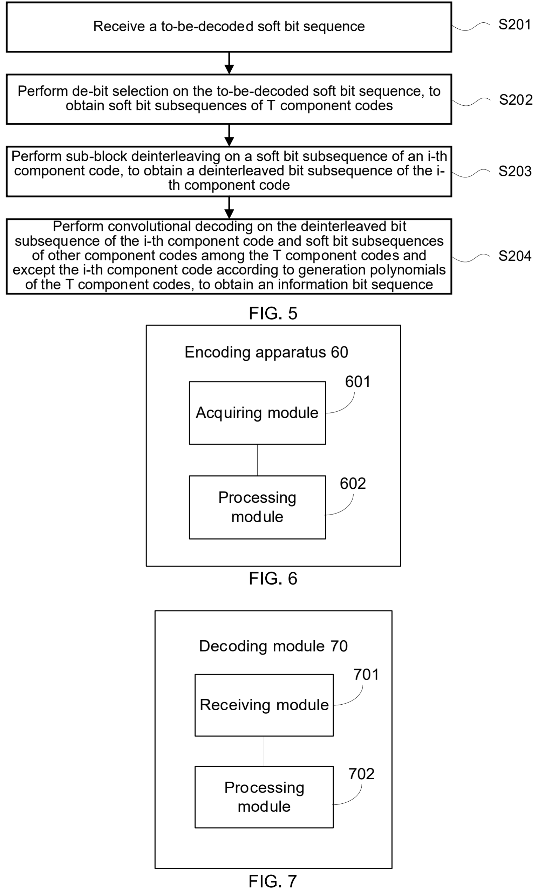

Based on the above embodiments, the method may perform convolutional encoding on the information bit sequence based on a preset component code generation polynomial, select one of the component code output bit sequences for sub-block interleaving, to obtain a sub-block interleaved output sequence, and determine the encoded bit sequence based on the sub-block interleaved output sequence and the other component code output bit sequences. In this scheme, sub-block interleaving is not required for the other component code output bit sequences. Thus, the interleaving process of convolutional encoding may be reduced and the complexity of encoding may be reduced. In some embodiments, the present disclosure also provides a decoding method, as shown in FIG. 5, and the method at least includes S201 to S204.

In S201, a to-be-decoded soft bit sequence is received.

The receiving end receives the soft bit sequence and may perform decoding operations on all or a part of the bits in the encoded bit sequence. Taking as an example of the communication system 100 shown in FIG. 1, the receiving end may be a terminal device or a network device in the communication system 100. In a communication process, if a network device sends data to a terminal device and the terminal device receives the data sent from the network device, the network device may be referred to as a sending end. Accordingly, the terminal device may be referred to as the receiving end.

In S202, de-bit selection is performed on the to-be-decoded soft bit sequence, to obtain soft bit subsequences of T component codes.

In S203, sub-block deinterleaving is performed on a soft bit subsequence of an i-th component code, to obtain a deinterleaved bit subsequence of the i-th component code.

Herein, i is a non-negative integer less than T.

In some embodiments, the value of i is determined according to one or more of: a number of component codes T, encoding rate, a number of sent bits, a number of resource elements, a length of an output bit sequence of a single component code among the T component codes, a modulation order, a number of multi-antenna layers, a constraint length for convolutional encoding, and a length of the information bit sequence.

Herein, for detailed explanation and implementation of the value of i, reference may be made to the relevant description in the above step S103, which will not be repeated herein.

In S204, convolutional decoding is performed on the deinterleaved bit subsequence of the i-th component code and soft bit subsequences of other component codes among the T component codes and except the i-th component code according to T component code generation polynomials, to obtain an information bit sequence.

Herein, T is an integer greater than 1. Exemplarily, values of T include 2, 3, 4, 6, 8, 10, or 12.

In some embodiments, the receiving end may also receive relevant information of the encoded bit sequence. Exemplarily, the relevant information may include T component code generation polynomials.

In some embodiments, the receiving end may also preset T component code generation polynomials, and the T component code generation polynomials are the same as the T component code generation polynomials used by the sending end to perform convolutional encoding to obtain the encoded bit sequence.

In some embodiments, a constraint length for the convolutional encoding is determined based on a highest power of a polynomial among the T component code generation polynomials. Exemplarily, the constraint length for the convolutional encoding may be a sum of the highest power of the polynomial among the T component code generation polynomials and 1.

In some embodiments, the constraint length for the convolutional encoding may be at least one of: 5, 6, 7, 8, 9, 10, 11. In an example, the constraint lengths for the convolutional encoding are 7 and 9. In another example, the constraint lengths for the convolutional encoding are 5 and 9. In yet another example, the constraint lengths for the convolutional encoding are equal to 7 and 11. In yet another example, the constraint lengths for the convolutional encoding are 7, 9, and 11.

Herein, for detailed explanation and implementation of the generation polynomial of the component code, reference may be made to the relevant description in the above step S102, which will not be repeated herein.

Based on the above embodiments, in the encoding process, one of the component code output bit sequences may be selected for sub-block interleaving, to obtain a sub-block interleaved output sequence and in the decoding process, only the soft bit subsequence corresponding to the component code may be sub-block deinterleaved, which may reduce the deinterleaving process of convolutional decoding and reduce the complexity of decoding.

The above introduces the solutions provided by the present disclosure mainly from the perspective of interaction between various nodes. It can be understood that, in order to implement the above functions, the various nodes, e.g., the apparatuses or devices, contain corresponding hardware structures and/or software modules for performing various functions. Those skilled in the art should easily realize that the present disclosure can be implemented in the form of hardware or a combination of hardware and computer software, in combination with the algorithm steps of various examples described in the embodiments disclosed herein. Whether a certain function is executed by hardware or by computer software driving hardware, depends on the specific applications and design constraint conditions of the technical solutions. Professional technicians may use different methods to implement the described functions, for each specific application, but this implementation should not be considered beyond the scope of the present disclosure.

FIG. 6 shows a schematic diagram of components of an encoding apparatus, provided by the embodiments of the present disclosure. As shown in FIG. 6, the encoding apparatus 60 includes an acquiring module 601 and a processing module 602.

In some embodiments, the acquiring module 601 is configured to: acquire an information bit sequence; and the processing module 602 is configured to perform convolutional encoding on the information bit sequence according to T component code generation polynomials, to obtain T component code output bit sequences, where T is an integer greater than 1. The processing module 602 is further configured to perform sub-block interleaving on an i-th component code output bit sequence, to obtain a sub-block interleaved output sequence, where i is a non-negative integer less than T. The processing module 602 is further configured to determine an encoded bit sequence according to the sub-block interleaved output sequence and other component code bit sequences among the T component code bit sequences and except the i-th component code bit sequence.

In some embodiments, a value of i is determined according to one or more of: a number of component codes T, encoding rate, a number of sent bits, a number of resource particles, a length of an output bit sequence of a single component code among the T component codes, a modulation order, a number of multi-antenna layers, a constraint length for convolutional coding, and a length of the information bit sequence.

In some embodiments, the value of i is determined based on a formula as follows:

$$i = \mathrm{mod}\left(\mathrm{floor}(1/R), T\right);$$

herein, R is the encoding rate, function floor(x) is a floor function, function mod (a, b) is a modulo operation and represents a remainder obtained by dividing a by b, R is a real number greater than 0, and a and b are positive integers.

In some embodiments, the value of i is determined based on a formula as follows:

$$i = \mathrm{mod}\left(\mathrm{floor}(E/K), T\right);$$

herein, K is the length of the information bit sequence, E is the number of sent bits, function floor(x) is a floor function, function mod (a, b) is a modulo operation, and represents a remainder obtained by dividing a by b, and K, E, a, and b are all positive integers.

In some embodiments, the value of i is determined based on a formula as follows:

$$i = \mathrm{mod}\left(\mathrm{floor}(E/M), T\right);$$

herein, M is the length of the output bit sequence of the single component code among the T component codes, E is the number of sent bits, function floor(x) is a floor function, function mod (a, b) is a modulo operation, and represents a remainder obtained by dividing a by b, and E, M, a, and b are all positive integers.

In some embodiments, the value of i is determined based on a formula as follows:

$$i = \mod \left( \text{floor}((S * Q)/M), T \right);$$

herein, M is the length of the output bit sequence of the single component code among the T component codes, S is the number of resource elements, Q is the modulation order, function floor(x) is a floor function, function mod (a, b) is a modulo operation, and represents a remainder obtained by dividing a by b, and S, Q, M, a, and b are all positive integers.

In some embodiments, the value of i is determined based on a formula as follows:

$$i = \mod \left( \text{floor}((S * Q * V)/M), T \right);$$

herein, M is the length of the output bit sequence of the single component code among the T component codes, S is the number of resource elements, Q is the modulation order, V is the number of multi-antenna layers, function floor(x) is a floor function, function mod (a, b) is a modulo operation, and represents a remainder obtained by dividing a by b, and S, Q, M, V, a, and b are all positive integers.

In some embodiments, the value of i is determined based on a formula as follows:

$$i = \text{floor}(E/M);$$

herein, M is the length of the output bit sequence of the single component code among the T component codes, E is the number of sent bits, and function floor(x) is a floor function.

In some embodiments, the sub-block interleaving is implemented based on an interleaving matrix and an inter-column permutation index set, and elements in the inter-column permutation index set are all non-negative integers.

In some embodiments, a number of columns of the interleaving matrix is determined based on a length of the inter-column permutation index set, and a number of rows of the interleaving matrix is determined based on a length of the i-th component code output bit sequence.

In some embodiments, a number of rows of the interleaving matrix satisfies a relationship as follows:

$$(R \cdot C) \geq M;$$

herein, R is the number of rows of the interleaving matrix, C is the number of columns of the interleaving matrix, and M is the length of the i-th component code output bit sequence.

In some embodiments, a length of the inter-column permutation index set is 8, 16, 32, or 64.

In some embodiments, a length of the inter-column permutation index set is 8, and the inter-column permutation index set is [0, 4, 2, 6, 1, 5, 3, 7] or [1, 5, 3, 7, 0, 4, 2, 6].

In some embodiments, a length of the inter-column permutation index set is 16, and the inter-column permutation index set is [0, 8, 4, 12, 2, 10, 6, 14, 1, 9, 5, 13, 3, 11, 7, 15] or [1, 9, 5, 13, 3, 11, 7, 15, 0, 8, 4, 12, 2, 10, 6, 14].

In some embodiments, a length of the inter-column permutation index set is 32, and the inter-column permutation index set is [0, 16, 8, 24, 4, 20, 12, 28, 2, 18, 10, 26, 6, 22, 14, 30, 1, 17, 9, 25, 5, 21, 13, 29, 3, 19, 11, 27, 7, 23, 15, 31].

In some embodiments, a length of the inter-column permutation index set is 64, and the inter-column permutation index set is [0, 32, 16, 48, 8, 40, 24, 56, 4, 36, 20, 52, 12, 44, 28, 60, 2, 34, 18, 50, 10, 42, 26, 58, 6, 38, 22, 54, 14, 46, 30, 62, 1, 33, 17, 49, 9, 41, 25, 57, 5, 37, 21, 53, 13, 45, 29, 61, 3, 35, 19, 51, 11, 43, 27, 59, 7, 39, 23, 55, 15, 47, 31, 63] or [1, 33, 17, 49, 9, 41, 25, 57, 5, 37, 21, 53, 13, 45, 29, 61, 3, 35, 19, 51, 11, 43, 27, 59, 7, 39, 23, 55, 15, 47, 31, 63, 0, 32, 16, 48, 8, 40, 24, 56, 4, 36, 20, 52, 12, 44, 28, 60, 2, 34, 18, 50, 10, 42, 26, 58, 6, 38, 22, 54, 14, 46, 30, 62].

For more detailed descriptions of the above acquiring module 601 and the processing module 602, and more detailed descriptions of various technical features therein, and descriptions of the beneficial effects, etc., references may be made to the above corresponding encoding method embodiment sections, which will not be repeated herein.

FIG. 7 shows a schematic diagram of components of a decoding apparatus, provided by the embodiments of the present disclosure. As shown in FIG. 7, the decoding apparatus 70 includes a receiving module 701 and a processing module 702.

In some embodiments, the receiving module 701 is configured to receive a to-be-decoded soft bit sequence. The processing module 702 is configured to perform de-bit selection on the to-be-decoded soft bit sequence, to obtain soft bit subsequences of T component codes. The processing module 702 is further configured to perform sub-block deinterleaving on a soft bit subsequence of an i-th component code, to obtain a deinterleaved bit subsequence of the i-th component code, where i is a non-negative integer less than T. The processing module 702 is further configured to perform convolutional decoding on the deinterleaved bit subsequence of the i-th component code and soft bit subsequences of other component codes among the T component codes and except the i-th component code according to T component code generation polynomials, to obtain an information bit sequence.

In some embodiments, the convolutional decoding is implemented based on Viterbi decoding or cyclic redundancy check (CRC)-assisted Viterbi table decoding.

For more detailed descriptions of the above receiving module 701 and the processing module 702, and more detailed descriptions of various technical features therein, and descriptions of the beneficial effects, etc., references may be made to the above corresponding encoding method embodiment sections, which will not be repeated herein.

It should be noted that, the modules in FIG. 6 and FIG. 7 may also be referred to as units, and for example, the processing module may be referred to as a processing unit. In addition, in the embodiments shown in FIG. 6 or FIG. 7, the names of the respective modules may not be the names shown in the figures, and for example, the acquiring module or the sending module may also be referred to as a communication module.

If each unit in FIG. 6 or FIG. 7 is implemented in the form of a software functional module, and sold or used as a separate product, the unit may be stored in a computer readable storage medium. Based on this understanding, the technical solutions of the embodiments of the present disclosure may be essentially, or a part of the technical solutions that contributes to the existing technology, or a part of all of the technical solutions, may be embodied in the form of a software product, and the computer software product is stored in a storage medium, and includes a plurality of instructions to cause a computer device (which may be a personal computer, a server, a network device, etc.) or processor to perform a part or all of the steps of the methods of various embodiments of the present disclosure. The storage medium storing the computer software product includes various types of medium capable of storing program codes, such as a U disk (USB flash disk), a mobile hard disk, a read-only memory (ROM), a random access memory (RAM), a magnetic disk, or an optical disk, etc.

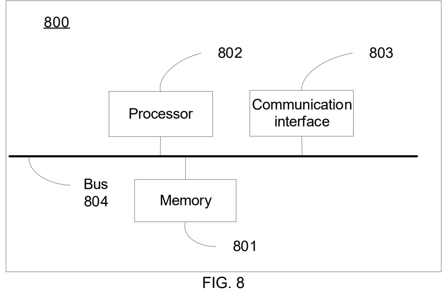

In a case where the functions of the above integrated modules are implemented in the form of hardware, the embodiments of the present disclosure provide a structural schematic diagram of a communication apparatus, the communication apparatus may be the above-mentioned encoding apparatus or decoding apparatus, as shown in FIG. 8. The communication apparatus 800 includes a processor 802, a communication interface 803, and a bus 804. Optionally, the communication apparatus 800 may also include a memory 801.

The processor 802 may implement or perform various exemplary logical blocks, modules and circuits described in conjunction with the content disclosed in the present disclosure. The processor 802 may be a central processing unit, a general-purpose processor, a digital signal processor, an application specific integrated circuit, a field programmable gate array or any other programmable logic device, a transistor logic device, a hardware component, or any combination thereof. The processor 802 may implement or perform various exemplary logical blocks, modules and circuits described in conjunction with the content disclosed in the present disclosure. The processor 802 may also be a combination that implements computing functions, for example, including a combination of one or more microprocessors, a combination of a digital signal processor (DSP) and a microprocessor, or the like.

The communication interface 803 is configured to connect with other devices via a communication network. The communication network may be an Ethernet, a radio access network, a wireless local area network (WLAN), or the like.

The memory 801 may be, but be not limited to, a read-only memory (ROM) or other types of static storage devices capable of storing static information and instructions, a random access memory (RAM) or other types of dynamic storage devices capable of storing information and instructions, or may also be an electrically erasable programmable read-only memory (EEPROM), a magnetic disk storage medium or other magnetic storage devices, or any other medium capable of being used to carry or store the desired program codes in the form of instructions or data structures and capable of being accessed by a computer.

As a possible implementation, the memory 801 may exist independently of the processor 802, and the memory 801 may be connected to the processor 802 via the bus 804 and is used for storing instructions or program codes. When calling and executing the instructions or the program codes stored in the memory 801, the processor 802 is capable of realizing the method provided by the embodiments of the present disclosure.

As another possible implementation, the memory 801 may also be integrated with the processor 802.

The bus 804 may be an extended industry standard architecture (EISA) bus or the like. Buses 804 may be divided into address buses, data buses, control buses, and the like. For ease of representation, only one bold line is used for the representation in FIG. 8, but it does not mean that there is only one bus or one type of the bus.

From the description of the above embodiments, those skilled in the art can clearly understand that, for convenience and brevity of description, an illustration is only given by the division of functional modules mentioned above. In practical applications, the functions mentioned above may be allocated to be completed by different functional modules according to requirements. That is, the internal structure of the device or apparatus is divided into different functional modules to complete all or a part of the functions mentioned above.

The embodiments of the present disclosure further provide a computer readable storage medium. All or a part of the procedures in the method embodiments mentioned above may be completed by related hardware indicated by computer instructions, and the program may be stored in the computer readable storage medium mentioned above. The program, when executed, may include the procedures of the method embodiments mentioned above. The computer readable storage medium may be or a memory of any one of the aforementioned embodiments. The computer readable storage medium mentioned above may also be an external storage device of the device or apparatus mentioned above, e.g., a plug-in hard disk, a smart memory card (smart media card, SMC), a secure digital (SD) card, a flash card, etc., equipped on the device or apparatus mentioned above. Furthermore, the computer-readable storage medium mentioned above may further include both an internal storage unit and an external storage device of the device or apparatus mentioned above. The computer readable storage medium mentioned above is used to store the computer program mentioned above, and other programs and data required for the device or apparatus mentioned above. The above-mentioned computer readable storage medium may also be used to temporarily store data that has been output or is to be output.

The embodiments of the present disclosure further provide a computer program product, the computer product contains a computer program, the computer program product, when executed on a computer, causes the computer to perform any one of the methods provided in the above embodiments.

Although the present disclosure is described herein in conjunction with respective embodiments, other variations of the disclosed embodiments may be understood and implemented by those skilled in the art by viewing the drawings, the disclosed content, and the attached claims, in the process of implementing the claimed processes of the present disclosure. In the claims, the word "comprise/comprises/comprising" does not exclude other components or steps, and "a/an" or "one" does not exclude multiple cases. A single processor or other unit may implement functions of several items listed in the claims. Although certain measures are recorded in dependent claims different from each other, it does not mean that these measures cannot be combined to exert a good effect.

Although the present disclosure is described in conjunction with specific features and embodiments thereof, it is apparent that various modifications and combinations may be made thereto without departing from the spirit and scope of the present disclosure. Accordingly, the specification and drawings are merely exemplary explanation of the present disclosure as defined by the attached claims and are deemed to cover any and all modifications, variations, combinations or equivalents within the scope of the present disclosure. Obviously, those skilled in the art may make various changes and variations to the present disclosure without departing from the spirit and scope of the present disclosure. In this way, if these modifications and variants of the present disclosure fall within the scope of the claims of the present disclosure and their equivalent technologies, the present disclosure is also intended to contain these modifications and variants.

The foregoing descriptions are merely specific implementations of the present disclosure, but the protection scope of the present disclosure is not limited thereto. Any change or replacement within the technical scope disclosed in the present disclosure shall be included in the protection scope of the present disclosure. Therefore, the protection scope of the present disclosure shall be determined based on the protection scope of the claims.

**Claims**

1. An encoding method, **characterized in that** the method comprises:

   acquiring an information bit sequence;
   performing convolutional encoding on the information bit sequence according to T component code generation polynomials, to obtain T component code output bit sequences, wherein T is an integer greater than 1;
   performing sub-block interleaving on an i-th component code output bit sequence, to obtain a sub-block interleaved output sequence, wherein i is a non-negative integer less than T; and
   determining an encoded bit sequence according to the sub-block interleaved output sequence and other component code bit sequences among the T component code bit sequences and except the i-th component code bit sequence.

2. The method according to claim 1, wherein a value of i is determined according to one or more of: a number of component codes T, encoding rate, a number of sent bits, a number of resource elements, a length of an output bit sequence of a single component code among T component codes, a modulation order, a number of multi-antenna layers, a constraint length for convolutional encoding, and a length of the information bit sequence.

3. The method according to claim 2, wherein the value of i is determined based on a formula as follows:

$$i = \mathrm{mod}\left(\mathrm{floor}(1/R), \mathrm{T}\right);$$

   wherein R is the encoding rate, function floor(x) is a floor function, function mod (a, b) is a modulo operation and represents a remainder obtained by dividing a by b, R is a real number greater than 0, and a and b are positive integers.

4. The method according to claim 2, wherein the value of i is determined based on a formula as follows:

$$i = \mathrm{mod}\ (\mathrm{floor}(E/K), T);$$

wherein K is the length of the information bit sequence, E is the number of sent bits, function floor(x) is a floor function, function mod (a, b) is a modulo operation, and represents a remainder obtained by dividing a by b, and K, E, a, and b are all positive integers.

5. The method according to claim 2, wherein the value of i is determined based on a formula as follows:

$$i = \mathrm{mod}\ (\mathrm{floor}(E/M), T);$$

wherein M is the length of the output bit sequence of the single component code among the T component codes, E is the number of sent bits, function floor(x) is a floor function, function mod (a, b) is a modulo operation, and represents a remainder obtained by dividing a by b, and E, M, a, and b are all positive integers.

6. The method according to claim 2, wherein the value of i is determined based on a formula as follows:

$$i = \mathrm{mod}\ (\mathrm{floor}((S * Q)/M), T);$$

wherein M is the length of the output bit sequence of the single component code among the T component codes, S is the number of resource elements, Q is the modulation order, function floor(x) is a floor function, function mod (a, b) is a modulo operation, and represents a remainder obtained by dividing a by b, and S, Q, M, a, and b are all positive integers.

7. The method according to claim 2, wherein the value of i is determined based on a formula as follows:

$$i = \mathrm{mod}\ (\mathrm{floor}((S * Q * V)/M), T);$$

wherein M is the length of the output bit sequence of the single component code among the T component codes, S is the number of resource elements, Q is the modulation order, V is the number of multi-antenna layers, function floor(x) is a floor function, function mod (a, b) is a modulo operation, and represents a remainder obtained by dividing a by b, and S, Q, M, V, a, and b are all positive integers.

8. The method according to claim 2, wherein the value of i is determined based on a formula as follows:

$$i = \mathrm{floor}(E/M);$$

wherein M is the length of the output bit sequence of the single component code among the T component codes E is the number of sent bits, function floor(x) is a floor function.

9. The method according to claim 1, wherein the sub-block interleaving is implemented based on an interleaving matrix and an inter-column permutation index set, and elements in the inter-column permutation index set are all non-negative integers.

10. The method according to claim 9, wherein a number of columns of the interleaving matrix is determined based on a length of the inter-column permutation index set, and a number of rows of the interleaving matrix is determined based on a length of the i-th component code output bit sequence.

11. The method according to claim 10, wherein a number of rows of the interleaving matrix satisfies a relationship as follows:

$$(R \cdot C) \geq M;$$

wherein R is the number of rows of the interleaving matrix, C is the number of columns of the interleaving matrix, and M is the length of the i-th component code output bit sequence.

**12.** The method according to claim 9, wherein a length of the inter-column permutation index set is 8, 16, 32, or 64.

**13.** The method according to claim 9, wherein a length of the inter-column permutation index set is 8, and the inter-column permutation index set is [0, 4, 2, 6, 1, 5, 3, 7] or [1, 5, 3, 7, 0, 4, 2, 6].

**14.** The method according to claim 9, wherein a length of the inter-column permutation index set is 16, and the inter-column permutation index set is [0, 8, 4, 12, 2, 10, 6, 14, 1, 9, 5, 13, 3, 11, 7, 15] or [1, 9, 5, 13, 3, 11, 7, 15, 0, 8, 4, 12, 2, 10, 6, 14].

**15.** The method according to claim 9, wherein a length of the inter-column permutation index set is 32, and the inter-column permutation index set is [0, 16, 8, 24, 4, 20, 12, 28, 2, 18, 10, 26, 6, 22, 14, 30, 1, 17, 9, 25, 5, 21, 13, 29, 3, 19, 11, 27, 7, 23, 15, 31].

**16.** The method according to claim 9, wherein a length of the inter-column permutation index set is 64, and the inter-column permutation index set is [0, 32, 16, 48, 8, 40, 24, 56, 4, 36, 20, 52, 12, 44, 28, 60, 2, 34, 18, 50, 10, 42, 26, 58, 6, 38, 22, 54, 14, 46, 30, 62, 1, 33, 17, 49, 9, 41, 25, 57, 5, 37, 21, 53, 13, 45, 29, 61, 3, 35, 19, 51, 11, 43, 27, 59, 7, 39, 23, 55, 15, 47, 31, 63] or [1, 33, 17, 49, 9, 41, 25, 57, 5, 37, 21, 53, 13, 45, 29, 61, 3, 35, 19, 51, 11, 43, 27, 59, 7, 39, 23, 55, 15, 47, 31, 63, 0, 32, 16, 48, 8, 40, 24, 56, 4, 36, 20, 52, 12, 44, 28, 60, 2, 34, 18, 50, 10, 42, 26, 58, 6, 38, 22, 54, 14, 46, 30, 62].

**17.** A decoding method, **characterized in that** the method comprises:

receiving a to-be-decoded soft bit sequence;
performing de-bit selection on the to-be-decoded soft bit sequence, to obtain soft bit subsequences of T component codes;
performing sub-block deinterleaving on a soft bit subsequence of an $i$-th component code, to obtain a deinterleaved bit subsequence of the $i$-th component code, wherein $i$ is a non-negative integer less than T; and
performing convolutional decoding on the deinterleaved bit subsequence of the $i$-th component code and soft bit subsequences of other component codes among the T component codes and except the $i$-th component code according to T component code generation polynomials, to obtain an information bit sequence.

**18.** The method according to claim 17, wherein the convolutional decoding is implemented based on Viterbi decoding or cyclic redundancy check (CRC)-assisted Viterbi table decoding.

**19.** A communication apparatus, **characterized by** comprising: a memory and a processor; wherein the memory is coupled with the processor; the memory is configured to store instructions executable by the processor; and the processor, when executing the instructions, performs the method according to any one of claims 1 to 18.

**20.** A computer readable storage medium, **characterized in that** the computer readable storage medium has stored computer instructions thereon, the computer instructions, when executed on a communication apparatus, cause the communication apparatus to perform the method according to any one of claims 1 to 18.

FIG. 1

| | |
|---|---|
| Acquire an information bit sequence | S101 |
| According to T component code generation polynomials, perform convolutional coding on the information bit sequence, so as to obtain T component code output bit sequences | S102 |
| Perform sub-block interleaving on an i-th component code output bit sequence, so as to obtain a sub-block interleaved output sequence | S103 |
| According to the sub-block interleaved output sequence and the other component code bit sequences excepting the i-th component code bit sequence among the T component code bit sequences, determine a coded bit sequence | S104 |

FIG. 2

$c_k^{(0)} g_0 = 133(\text{octal})$

$c_k^{(1)} g_1 = 171(\text{octal})$

$c_k^{(2)} g_2 = 165(\text{octal})$

$c_k^{(3)} g_3 = 123(\text{octal})$

FIG. 3

FIG. 4

Receive a to-be-decoded soft bit sequence — S201

Perform de-bit selection on the to-be-decoded soft bit sequence, to obtain soft bit subsequences of T component codes — S202

Perform sub-block deinterleaving on a soft bit subsequence of an i-th component code, to obtain a deinterleaved bit subsequence of the i-th component code — S203

Perform convolutional decoding on the deinterleaved bit subsequence of the i-th component code and soft bit subsequences of other component codes among the T component codes and except the i-th component code according to generation polynomials of the T component codes, to obtain an information bit sequence — S204

FIG. 5

Encoding apparatus 60

Acquiring module — 601

Processing module — 602

FIG. 6

Decoding module 70

Receiving module — 701

Processing module — 702

FIG. 7

FIG. 8

## INTERNATIONAL SEARCH REPORT

| | International application No. |
|---|---|
| | **PCT/CN2024/071818** |

**A. CLASSIFICATION OF SUBJECT MATTER**

H04L1/00(2006.01)i

According to International Patent Classification (IPC) or to both national classification and IPC

**B. FIELDS SEARCHED**

Minimum documentation searched (classification system followed by classification symbols)

IPC: H04L

Documentation searched other than minimum documentation to the extent that such documents are included in the fields searched

Electronic data base consulted during the international search (name of data base and, where practicable, search terms used)

CNTXT, ENTXT, ENTXTC, WPABS, 3GPP: 分量码, 分量编码, 子块, 分块, 交织, 多项式, 比特, 收集, 选择, subblock, interleaving, interleaver, component, code, encoder, bit, grouping, collection

**C. DOCUMENTS CONSIDERED TO BE RELEVANT**

| Category* | Citation of document, with indication, where appropriate, of the relevant passages | Relevant to claim No. |
|---|---|---|
| X | CN 109391365 A (HUAWEI TECHNOLOGIES CO., LTD.) 26 February 2019 (2019-02-26) description, paragraphs 0056-0115, and figures 4-6 | 1, 9, 17-20 |
| X | CN 110447187 A (IDAC HOLDINGS, INC.) 12 November 2019 (2019-11-12) claims 1-11, and description, paragraph 0168 | 1, 9, 17-20 |
| A | CN 101860412 A (ZTE CORP.) 13 October 2010 (2010-10-13) entire document | 1-20 |
| A | CN 107786300 A (ZTE CORP.) 09 March 2018 (2018-03-09) entire document | 1-20 |
| A | US 2011060970 A1 (KIM, So Yeon et al.) 10 March 2011 (2011-03-10) entire document | 1-20 |
| A | MOTOROLA. "Convolutional Code Rate Matching in LTE" *3GPP TSG RAN1 #49bis, R1-072670.* 29 June 2007 (2007-06-29), entire document | 1-20 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **13 March 2024** | **19 March 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

EP 4 716 124 A1

| INTERNATIONAL SEARCH REPORT | | | | International application No. |
|---|---|---|---|---|
| Information on patent family members | | | | PCT/CN2024/071818 |

| Patent document cited in search report | | | Publication date (day/month/year) | Patent family member(s) | | | Publication date (day/month/year) |
|---|---|---|---|---|---|---|---|
| CN | 109391365 | A | 26 February 2019 | US | 2020119846 | A1 | 16 April 2020 |
| | | | | EP | 3605904 | A1 | 05 February 2020 |
| | | | | WO | 2019029397 | A1 | 14 February 2019 |
| CN | 110447187 | A | 12 November 2019 | KR | 20220105681 | A | 27 July 2022 |
| | | | | WO | 2018175557 | A1 | 27 September 2018 |
| | | | | US | 2023275697 | A1 | 31 August 2023 |
| | | | | EP | 3602868 | A1 | 05 February 2020 |
| | | | | US | 2022376826 | A1 | 24 November 2022 |
| | | | | US | 2021385016 | A1 | 09 December 2021 |
| | | | | US | 2020099471 | A1 | 26 March 2020 |
| | | | | JP | 2020516117 | A | 28 May 2020 |
| | | | | KR | 20210064401 | A | 02 June 2021 |
| | | | | EP | 4258555 | A2 | 11 October 2023 |
| | | | | JP | 2023106572 | A | 01 August 2023 |
| | | | | KR | 20200002799 | A | 08 January 2020 |
| | | | | CN | 115549856 | A | 30 December 2022 |
| CN | 101860412 | A | 13 October 2010 | WO | 2010118591 | A1 | 21 October 2010 |
| CN | 107786300 | A | 09 March 2018 | None | | | |
| US | 2011060970 | A1 | 10 March 2011 | KR | 20080112088 | A | 24 December 2008 |
| | | | | WO | 2008156335 | A2 | 24 December 2008 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310583281